# EUROPEAN PATENT APPLICATION

(11) **EP 4 672 216 A1**
(43) Date of publication of application: **31.12.2025**
(21) Application number: 25184318.1
(22) Date of filing: 20.06.2025
(51) Int. Cl.: G09G 3/3233

(54) **PIXEL AND ELECTRONIC DEVICE**

(30) Priority: 26.06.2024 KR 20240083469
(71) Applicant: Samsung Display Co., Ltd., Yongin-si, Gyeonggi-do (KR)
(72) Inventor: KIM, Sunho, Yongin-si (KR); KO, Yoomin, Yongin-si (KR); PARK, Juchan, Yongin-si (KR); CHOI, Chung Sock, Yongin-si (KR)
(74) Representative: Marks & Clerk LLP

(57) **Abstract**

A pixel includes: a light emitting element including an anode connected to a first driving voltage line and a cathode connected to a first node; a first transistor including a first electrode, a second electrode, a gate electrode, and a lower gate electrode; a second transistor connected between a data line and the gate electrode of the first transistor; a fifth transistor connected between the first node and the first electrode of the first transistor; a sixth transistor connected between the second electrode of the first transistor and a second driving voltage line; a seventh transistor connected between the first electrode of the first transistor and the lower gate electrode; a first capacitor connected between the gate electrode of the first transistor and the second electrode; and a second capacitor connected between the lower gate electrode of the first transistor and the second electrode.

## Description

### BACKGROUND

Aspects of some embodiments of the present invention relate to an electronic device including a pixel.

Generally, a light-emitting electronic device displays images by using a light emitting element that emits light, as electrons and holes are recombined with each other. Light-emitting electronic devices generally have a relatively rapid response speed and may be driven with relatively lower power consumption.

Light-emitting electronic devices include pixels connected to data lines and scan lines. Each of the pixels may include a light emitting element and a pixel circuit to control an amount of current flowing through the light emitting element. The pixel circuit controls the amount of current flowing through the light emitting element, in response to a data signal. In this case, light having a specific brightness is generated to correspond to the amount of current flowing through a light emitting element.

The above information disclosed in this Background section is only for enhancement of understanding of the background and therefore the information discussed in this Background section does not necessarily constitute prior art.

### SUMMARY

Aspects of some embodiments of the present disclosure include an electronic device including a pixel with relatively improved display quality.

According to some embodiments of the present disclosure, a pixel includes a light emitting element including an anode connected to a first driving voltage line and a cathode connected to a first node, a first transistor including a first electrode, a second electrode, a gate electrode, and a lower gate electrode, a second transistor connected between a data line and the gate electrode of the first transistor, a fifth transistor connected between the first node and the first electrode of the first transistor, a sixth transistor connected between the second electrode of the first transistor and a second driving voltage line, a seventh transistor connected between the first electrode of the first transistor and the lower gate electrode, a first capacitor connected between the gate electrode of the first transistor and the second electrode, and a second capacitor connected between the lower gate electrode of the first transistor and the second electrode.

According to some embodiments, the second transistor may include a gate electrode configured to receive a first scan signal. The fifth transistor may include a gate electrode configured to receive a first light emitting signal. The sixth transistor may include a gate electrode configured to receive a second light emitting signal. The seventh transistor may include a gate electrode configured to receive a second scan signal.

According to some embodiments, the pixel may further include a third transistor connected between a third driving voltage line configured to receive a first initializing voltage and the gate electrode of the first transistor. The pixel may include a fourth transistor connected between a fourth driving voltage line configured to receive a second initializing voltage and the first electrode of the first transistor.

According to some embodiments, the second initializing voltage may have a voltage level higher than a voltage level of the first initializing voltage.

According to some embodiments, the second initializing voltage may have a voltage level higher than a voltage level of a second driving voltage received through the second driving voltage line.

According to some embodiments, the third transistor may include a gate electrode configured to receive a second scan signal. The fourth transistor may include a gate electrode configured to receive a third scan signal.

According to some embodiments, the third transistor, the fourth transistor, the fifth transistor, and the seventh transistor may be configured to be turned on for an initializing period.

According to some embodiments, a threshold voltage of the first transistor may be negative-shifted for the initializing period.

According to some embodiments, the first transistor, the third transistor, the sixth transistor, and the seventh transistor may be turned on for a compensating period.

According to some embodiments, a threshold voltage of the first transistor may be configured to be set to 0 V for the compensating period.

According to some embodiments, the second transistor and the sixth transistor may be configured to be turned on for a write period.

According to some embodiments, the fourth transistor may be configured to be turned on for a light emitting element initializing period.

According to some embodiments, the first transistor, the fifth transistor, and the sixth transistor may be configured to be turned on for a light emitting period.

According to some embodiments, each of the first transistor, the second transistor, the fifth transistor, the sixth transistor, and the seventh transistor may be an N-type transistor.

According to some embodiments, a pixel includes a light emitting element including an anode connected to a first driving voltage line and a cathode connected to a first node, a first transistor including a first electrode, a second electrode, a gate electrode, and a lower gate electrode, a second transistor connected between a data line and a second node, a third transistor connected between the second electrode and a third driving voltage line, a fourth transistor connected between a fourth driving voltage line and the first node, a fifth transistor connected between the first node and the first electrode of the first transistor, a sixth transistor connected between the second electrode of the first transistor and a second driving voltage line, a seventh transistor connected between the first electrode of the first transistor and the gate electrode, a first capacitor connected between the gate electrode of the first transistor and the second node, and a second capacitor connected between the fifth driving voltage line and the second node.

According to some embodiments, the second transistor may include a gate electrode configured to receive a first scan signal, each of the third transistor and the seventh transistor may include a gate electrode configured to receive a third scan signal, the fourth transistor may include a gate electrode configured to receive a second scan signal, the fifth transistor may include a gate electrode configured to receive a first light emitting signal, and the sixth transistor may include a gate electrode configured to receive a second light emitting signal.

According to some embodiments, the third transistor, the fourth transistor, the fifth transistor, and the seventh transistor may be configured to be turned on for an initializing period.

According to some embodiments, the first transistor, the third transistor, the sixth transistor, and the seventh transistor may be configured to be turned on for a compensating period.

According to some embodiments, the initializing period and the compensating period may be alternately repeated twice.

According to some embodiments, the second transistor may be configured to be turned on for a write period.

According to some embodiments, the fourth transistor may be configured to be turned on for a light emitting element initializing period.

According to some embodiments, the first transistor, the fifth transistor, and the sixth transistor may be configured to be turned on for a light emitting period.

According to some embodiments of the present disclosure, an electronic device includes a display panel including a pixel, and a data driving circuit configured to provide a data signal to the pixel, wherein the pixel includes a light emitting element including an anode connected to a first driving voltage line and a cathode connected to a first node, a first transistor including a first electrode, a second electrode, a gate electrode, and a lower gate electrode, a second transistor connected between a data line configured to transmit the data signal and the gate electrode of the first transistor, a fifth transistor connected between the first node and the first electrode of the first transistor, a sixth transistor connected between the second electrode of the first transistor and a second driving voltage line, a seventh transistor connected between the first electrode of the first transistor and the lower gate electrode, a first capacitor connected between the gate electrode of the first transistor and the second electrode, and a second capacitor connected between the lower gate electrode of the first transistor and the second electrode.

According to some embodiments, in the pixel, the second transistor may include a gate electrode configured to receive a first scan signal. The fifth transistor may include a gate electrode configured to receive a first light emitting signal. The sixth transistor may include a gate electrode configured to receive a second light emitting signal. The seventh transistor may include a gate electrode configured to receive a second scan signal.

According to some embodiments, the pixel may further include a third transistor connected between a third driving voltage line configured to receive a first initializing voltage and the gate electrode of the first transistor. The pixel may include a gate electrode configured to receive the second light emitting signal. The pixel may include a fourth transistor connected between a fourth driving voltage line configured to receive a second initializing voltage and the first electrode of the first transistor, and including a gate electrode configured to receive a third scan signal.

According to some embodiments, the electronic device may include a scan driving circuit configured to provide the first scan signal, the second scan signal, and the third scan signal. The electronic device may include a light emitting driving circuit configured to provide the first light emitting signal and the second light emitting signal. The electronic device may include a voltage generator configured to provide a first driving voltage, a second driving voltage, the first initializing voltage, and the second initializing voltage to the first to fourth driving voltage lines.

According to some embodiments, the third transistor, the fourth transistor, the fifth transistor, and the seventh transistor may be configured to be turned on for an initializing period. A threshold voltage of the first transistor may be negative-shifted for the initializing period.

According to some embodiments, the first transistor, the third transistor, the sixth transistor, and the seventh transistor may be configured to be turned on for a compensating period. A threshold voltage of the first transistor may be set to 0 V for the compensating period.

At least some of the above and other features of the invention are set out in the claims.

### BRIEF DESCRIPTION OF THE DRAWINGS

The above and other aspects and features of embodiments according to the present disclosure will become more apparent by describing in more detail aspects of some embodiments thereof with reference to the accompanying drawings.
FIG. 1 is a block diagram of an electronic device according to some embodiments of the present disclosure.
FIG. 2 is a circuit diagram illustrating the operation of a pixel according to some embodiments of the present disclosure.
FIG. 3 is a timing diagram illustrating the operation of a pixel according to some embodiments of the present disclosure.
FIGS. 4A to 4E are circuit diagrams illustrating the operation of a pixel according to some embodiments of the present disclosure.
FIG. 5 is a view illustrating a threshold voltage Vth of the first transistor as a function of a body-source voltage of a first transistor.
FIG. 6 is a block diagram of an electronic device according to some embodiments of the present disclosure.
FIG. 7 is a circuit diagram of a pixel according to some embodiments of the present disclosure.
FIG. 8 is a timing diagram illustrating the operation of a pixel according to some embodiments of the present disclosure.
FIGS. 9A to 9E are circuit diagrams illustrating the operation of the pixel according to some embodiments of the present disclosure.
FIG. 10 is a cross-sectional view of a display panel according to some embodiments of the present disclosure.
FIG. 11A is an enlarged cross-sectional view according to some embodiments of the present disclosure, in which region BA of FIG. 10 is enlarged.
FIG. 11B is an enlarged cross-sectional view according to some embodiments of the present disclosure, in which region BB of FIG. 10 is enlarged.
FIG. 12 is a cross-sectional view of a display panel according to some embodiments of the present disclosure.
FIGS. 13A to 13C are plan views illustrating an enlarged partial region of a display panel according to some embodiments.

### DETAILED DESCRIPTION

In the specification, the expression that a first component (or region, layer, or part) is "on", "connected to", or "coupled to" a second component refers to that the first component is directly on, connected to, or coupled to the second component or refers to that a third component is interposed therebetween.

The same reference numerals will be assigned to the same components in drawings. In addition, in drawings, thicknesses, proportions, and dimensions of components may be exaggerated to describe the technical features effectively. The term "and/or" includes at least one combination of associated components

Although the terms "first", or "second" may be used to describe various components, the components should not be construed as being limited by the terms. The terms are only used to distinguish one component from another component. For example, without departing from the scope of the present disclosure, a first component may be referred to as a second component, and similarly, the second component may be referred to as the first component. The singular forms are intended to include the plural forms unless the context clearly indicates otherwise.

In addition, the terms "under", "at a lower portion", "above", "an upper portion" are used to describe the relationship between components illustrated in drawings. The terms are relative and will be described with reference to a direction indicated in the drawing.

It will be further understood that the terms "comprises," "comprising," "includes," or "including," or "having" specify the presence of stated features, numbers, steps, operations, components, parts, or the combination thereof, but do not preclude the presence or addition of one or more other features, numbers, steps, operations, components, components, and/or the combination thereof.

Unless defined otherwise, all terms (including technical terms and scientific terms) used in the specification have the same meaning as commonly understood by one skilled in the art to which the present disclosure pertains. Furthermore, terms such as terms defined in the dictionaries commonly used should be interpreted as having a meaning consistent with the meaning in the context of the related technology, and should not be interpreted in ideal or overly formal meanings unless explicitly defined herein.

Hereinafter, aspects of some embodiments of the present disclosure will be described in more detail with reference to drawings.

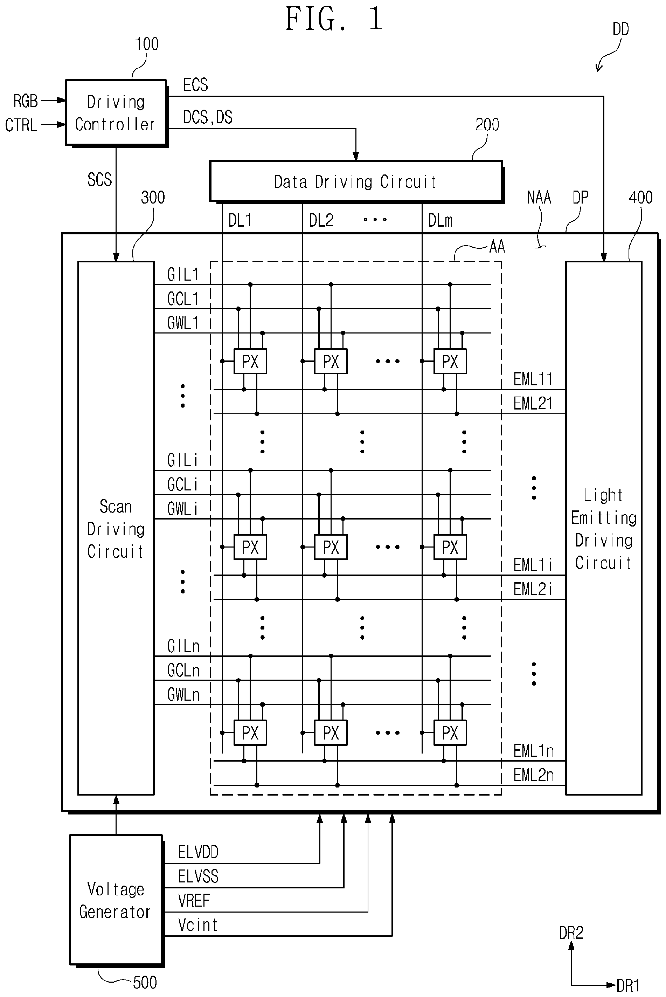

FIG. 1 is a block diagram of an electronic device DD according to some embodiments of the present disclosure.

Referring to FIG. 1, the electronic device DD includes a display panel DP, a driving controller 100, a data driving circuit 200, a scan driving circuit 300, a light emitting driving circuit 400, and a voltage generator 500.

The driving controller 100 receives an image signal RGB and a control signal CTRL. The driving controller 100 transforms the image signal RGB into an image data signal DS and outputs a transform result. The driving controller 100 outputs a scan control signal SCS, a data control signal DCS, and a light emitting control signal ECS.

The data driving circuit 200 receives the data control signal DCS and the image data signal DS from the driving controller 100. The data driving circuit 200 transforms the image data signal DS into data signals, and outputs the data signals to a plurality of data lines DL1 to DLm to be described later.

The scan driving circuit 300 receives the scan control signal SCS from the driving controller 100. In addition, the scan driving circuit 300 may output scan signals to first scan lines GWL1 to GWLn, second scan lines GCL1 to GCLn, and third scan lines GIL1 to GILn, in response to the scan control signal SCS.

The light emitting driving circuit 400 receives the light emitting control signal ECS from the driving controller 100. The light emitting driving circuit 400 may output light emitting signals to first light emitting lines EML11 to EML1n, and second light emitting lines EML21 to EML2n, in response to the light emitting control signal ECS.

The voltage generator 500 generates voltages necessary for an operation of the display panel DP. According to some embodiments, the voltage generator 500 may generate a first driving voltage ELVDD, a second driving voltage ELVSS, a first initializing voltage VREF, and a second initializing voltage Vcint necessary for the operation of the display panel DP.

The display panel DP may include the first scan lines GWL1 to GWLn, the second scan lines GCL1 to GCLn, the third scan lines GIL1 to GILn, the first light emitting lines EML11 to EML1n, the second light emitting lines EML21 to EML2n, the data lines DL1 to DLm, and a plurality of pixels PX.

The display panel DP includes an active region AA and a non-active region NAA. According to some embodiments, the pixels PX may be located in the active region AA of the display panel DP, and the scan driving circuit 300 and the light emitting driving circuit 400 may be located in the non-active region NAA of the display panel DP.

According to some embodiments, the scan driving circuit 300 is arranged to be adjacent to a first side of the active region AA. The first scan lines GWL1 to GWLn, the second scan lines GCL1 to GCLn, and the third scan lines GIL1 to GILn extend in a first direction DR1 from the scan driving circuit 300. The light emitting driving circuit 400 is arranged to be adjacent to a second side of the active region AA. The first light emitting lines EML11 to EML1n, and the second light emitting lines EML21 to EML2n extend in a direction opposite to the first direction DR1 from the light emitting driving circuit 400.

The first scan lines GWL1 to GWLn, the second scan lines GCL1 to GCLn, the third scan lines GIL1 to GILn, the first light emitting lines EML11 to EML1n, and the second light emitting lines EML21 to EML2n are arranged to be spaced apart from each other in a second direction DR2. The data lines DL1 to DLm extend in a direction opposite to the second direction DR2 from the data driving circuit 200, and may be arranged to be spaced apart from each other in the first direction DR1.

According to some embodiments as illustrated in FIG. 1, the scan driving circuit 300 and the light emitting driving circuit 400 are arranged to face each other while the pixels PX are interposed between the scan driving circuit 300 and the light emitting driving circuit 400. However, embodiments according to the present disclosure are not limited thereto. For example, the scan driving circuit 300 and the light emitting driving circuit 400 may be adjacent to each other in the non-active region NAA of the display panel DP. According to some embodiments, the scan driving circuit 300 and the light emitting driving circuit 400 may be integrally implemented in the form of one circuit.

A plurality of pixels PX are electrically connected to the first scan lines GWL1 to GWLn, the second scan lines GCL1 to GCLn, the third scan lines GIL1 to GILn, the first light emitting lines EML11 to EML1n, the second light emitting lines EML21 to EML2n, and the data lines DL1 to DLm.

Each of the plurality of pixels PX may be connected to three scan lines and two light emitting lines. For example, as illustrated in FIG. 1, pixels PX in a first row may be connected to the first scan line GWL1, the second scan line GCL1, the third scan line GIL1, the first light emitting line EML11, and the second light emitting line EML21. In addition, pixels PX in an i-th row may be connected to the first scan line GWLi, the second scan line GCLi, the third scan line GILi, the first light emitting line EML1i, and the second light emitting line EML2i. Pixels PX in an n-th row may be connected to the first scan line GWLn, the second scan line GCLn, the third scan line GILn, the first light emitting line EML1n, and the second light emitting line EML2n.

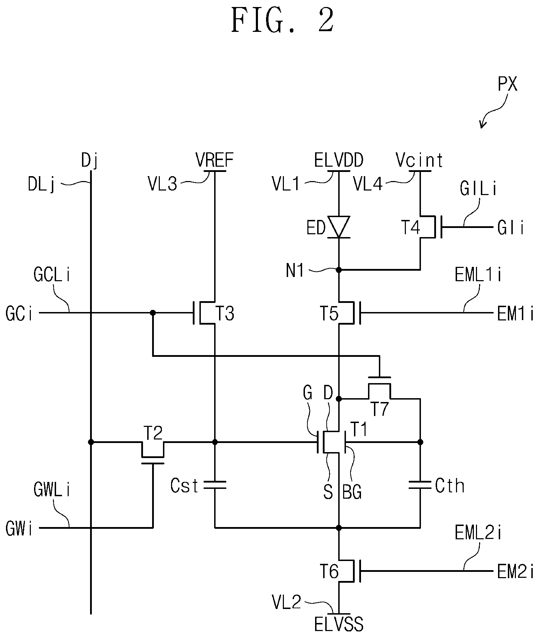

Each of the plurality of pixels PX may include a light emitting element ED (refer to FIG. 2) and a plurality of transistors T1 to T7 (refer to FIG. 2) to control a light emitting operation of the light emitting element ED. The scan driving circuit 300 and the light emitting driving circuit 400 may include transistors formed through the same process as processes for the plurality of transistors T1 to T7.

FIG. 2 is a circuit diagram of the pixel PX according to some embodiments of the present disclosure. Although FIG. 2 illustrates various components in a pixel according to some embodiments, embodiments according to the present disclosure are not limited thereto, and according to various embodiments, the pixel may include additional components or fewer components without departing from the scope of embodiments according to the present disclosure.

FIG. 2 illustrates the circuit diagram of the pixel PX connected to the j-th data line DLj of the data lines DL1 to DLm illustrated in FIG. 1, the first scan line GWLi of the first scan lines GWL1 to GWLn, the second scan line GCLi of the second scan lines GCL1 to GCLn, the third scan line GILi of the third scan lines GIL1 to GILn, the first light emitting line EML1i of the first light emitting lines EML11 to EML1n, and the second light emitting line EML2i of the second light emitting lines EML21 to EML2n, by way of example.

Each of pixels PX illustrated in FIG. 1 may have the same circuit configuration as the pixel PX illustrated in FIG. 2.

Referring to FIG. 2, the pixel PX of the electronic device according to some embodiments includes at least one light emitting element ED, the first to seventh transistors T1, T2, T3, T4, T5, T6, and T7, a first capacitor Cst, and a second capacitor Cth.

According to some embodiments, the light emitting element ED may be a light emitting diode. In the following description according to some embodiments, one pixel PX includes one light emitting element ED by way of example.

According to some embodiments, each of the first to seventh transistors T1 to T7 may be an N-type transistor including a semiconductor layer including an oxide semiconductor. However, embodiments according to the present disclosure are not limited thereto. For example, at least one of the first to seventh transistors T1 to T7 may be a P-type transistor having a low-temperature polycrystalline silicon (LTPS) semiconductor layer. In addition, according to the present disclosure, the circuit configuration of the pixel PX is not limited to that of FIG. 2, but may be modified.

The first scan line GWLi, the second scan line GCLi, and the third scan line GILi transmit a first scan signal GWi, a second scan signal GCi, and a third scan signal Gli provided from the scan driving circuit 300 (refer to FIG. 1).

The first light emitting line EML1i and the second light emitting line EML2i may transmit a first light emitting signal EM1i and a second light emitting signal EM2i provided from the light emitting driving circuit 400 (refer to FIG. 1).

The data line DLj transmits a data signal Dj provided from the data driving circuit 200 (refer to FIG. 1). The data signal Dj may have a voltage level corresponding to the image signal RGB input to the electronic device DD (refer to FIG. 1). First to fourth driving voltage lines VL1, VL2, VL3, and VL4 may transmit the first driving voltage ELVDD, the second driving voltage ELVSS, the first initializing voltage VREF, and the second initializing voltage Vcint, respectively.

The light emitting element ED is connected between the first driving voltage line VL1 and a first node N1. In other words, the light emitting element ED has an anode connected to the first driving voltage line VL1 and a cathode connected to the first node N1.

The first transistor T1 includes a first electrode D, a second electrode S, a gate electrode G, and a lower gate electrode BG. The lower gate electrode BG may be referred to as a body electrode or a back-gate electrode.

The second transistor T2 is connected between the data line DLj and the gate electrode G of the first transistor T1, and includes a gate electrode connected to the first scan line GWLi.

The third transistor T3 is connected between the third driving voltage line VL3 and the gate electrode G of the first transistor T1, and includes a gate electrode connected to the second scan line GCLi.

The fourth transistor T4 is connected between the fourth driving voltage line VL4 and the first node N1, and includes a gate electrode connected to the third scan line GILi.

The fifth transistor T5 is connected between the first node N1 and the first electrode D of the first transistor T1, and includes a gate electrode connected to the first light emitting line EML1i.

The sixth transistor T6 is connected between the second electrode S of the first transistor T1 and the second driving voltage line VL2, and include a gate electrode connected to the second light emitting line EML2i.

The seventh transistor T7 is connected between the first electrode D of the first transistor T1 and the lower gate electrode BG of the first transistor T1, and includes a gate electrode connected to the second scan line GCLi.

The first capacitor Cst is connected between the gate electrode G of the first transistor T1 and the second electrode S of the first transistor T1.

The second capacitor Cth is connected between the lower gate electrode BG of the first transistor T1 and the second electrode S of the first transistor T1.

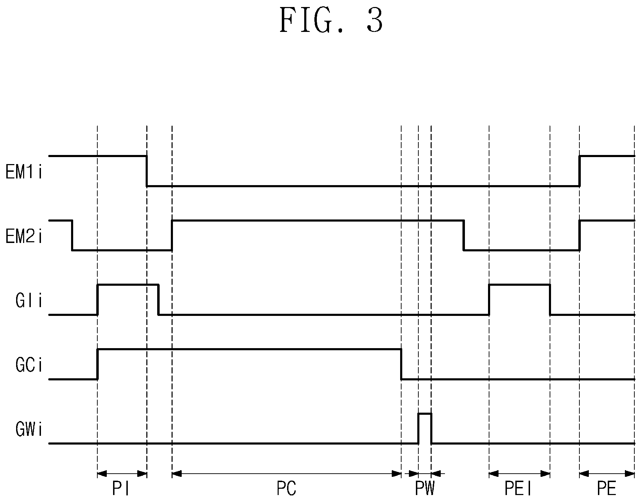

FIG. 3 is a timing diagram illustrating the operation of a pixel PX according to some embodiments of the present disclosure.

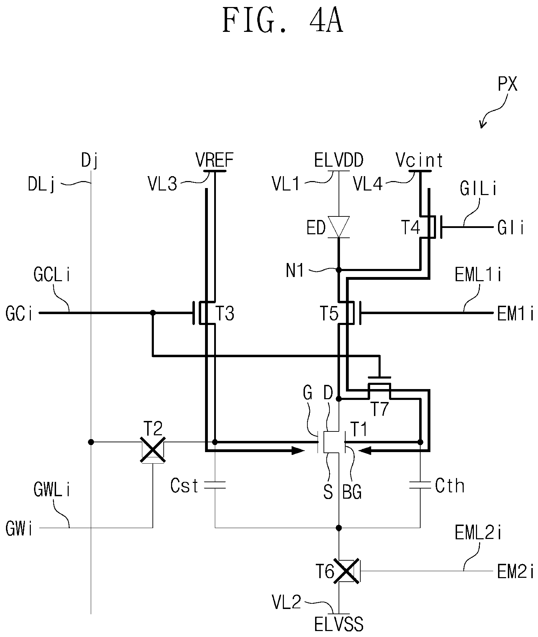

FIGS. 4A to 4E are circuit diagrams illustrating the operation of the pixel PX according to some embodiments of the present disclosure.

Referring to FIGS. 3 and 4A, each of the first light emitting signal EM1i, the second scan signal GCi, and the third scan signal Gli is in an active level (for example, a high level), and each of the second light emitting signal EM2i and the first scan signal GWi is in an inactive level (for example, a low level), for an initializing period PI.

During the high level of the first light emitting signal EM1i, the second scan signal GCi, and the third scan signal Gli, the third, fourth, fifth, and seventh transistors T3, T4, T5, and T7 are turned on.

Accordingly, for the initializing period PI, the first initializing voltage VREF is transmitted to the gate electrode G of the first transistor T1 through the third transistor T3. In addition, for the initializing period PI, the second initializing voltage Vcint is transmitted to the lower gate electrode BG of the first transistor T1 through the fourth, fifth, and seventh transistors T4, T5, and T7. In other words, for the initializing period PI, the first initializing voltage VREF may be transmitted to the gate electrode G of the first transistor T1, and the second initializing voltage Vcint may be transmitted to the lower gate electrode BG of the first transistor T1. The initializing period PI may be an initializing period for initializing voltages of the gate electrode G and the lower gate electrode BG of the first transistor T1 to a specific voltage.

According to some embodiments, the second initializing voltage Vcint may be higher than each of the first initializing voltage VREF and the second driving voltage ELVSS. When a voltage level of the lower gate electrode BG of the first transistor T1 rises, a body-source voltage (referred to as a "Vbs") becomes higher than 0 V (Vbs >0). Accordingly, for the initializing period PI, a threshold voltage Vth of the first transistor T1 may be negative-shifted.

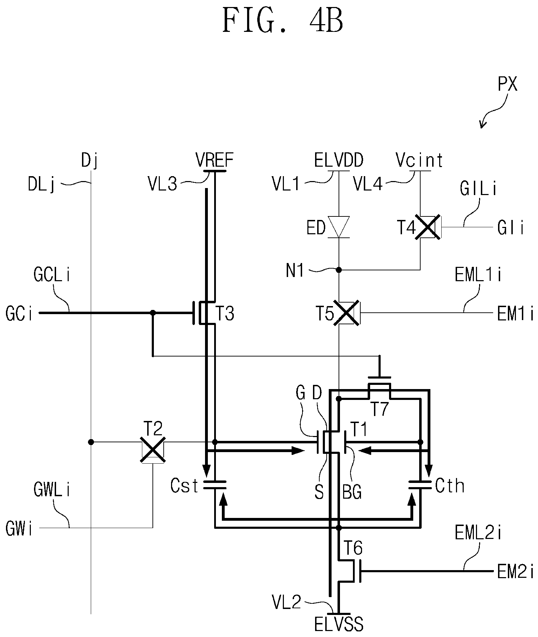

Referring to FIGS. 3 and 4B, each of the second light emitting signal EM2i and the second scan signal GCi is in an active level (for example, a high level), and each of the first light emitting signal EM1i, the first scan signal GWi, and the third scan signal Gli is in an inactive level (for example, a low level), for the compensating period PC.

During the high level of the second light emitting signal EM2i, and the second scan signal GCi, the third, sixth, and seventh transistors T3, T6, and T7 are turned on.

Accordingly, for the compensating period PC, the first initializing voltage VREF is transmitted to the gate electrode G of the first transistor T1 through the third transistor T3. In addition, for the compensating period PC, the second driving voltage ELVSS is transmitted to the lower gate electrode BG of the first transistor T1 through the sixth, first, and seventh transistors T6, T1, and T7.

In other words, for the compensating period PC, the first initializing voltage VREF may be transmitted to the gate electrode G of the first transistor T1, and the second driving voltage ELVSS may be transmitted to the lower gate electrode BG of the first transistor T1.

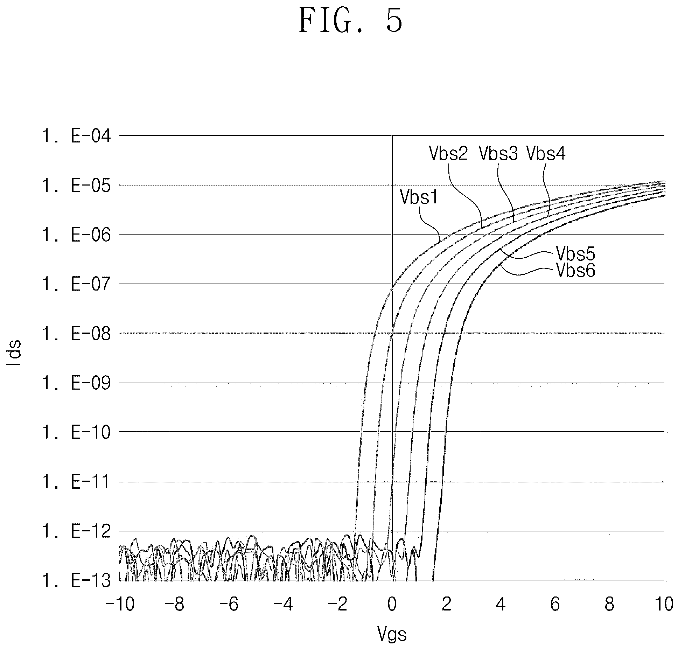

FIG. 5 is a view illustrating a threshold voltage Vth of the first transistor T1 depending on the body-source voltage Vbs of the first transistor T1.

Referring to FIGS. 4B and 5, voltage levels of body-source voltages Vbs1, Vbs2, Vbs3, Vbs4, Vbs5, and Vbs6 of the first transistor T1 have the relationship of Vbs1>Vbs2>Vbs3>Vbs4>Vbs5>Vbs6.

In other words, as the body-source voltage Vbs of the first transistor T1 is increased, the threshold voltage Vth of the first transistor T1 is more negative-shifted. As the body-source voltage Vbs of the first transistor T1 is decreased, the threshold voltage Vth of the first transistor T1 is more positive-shifted.

Referring back to FIGS. 3 and 4B, as the second driving voltage ELVSS is transmitted to the lower gate electrode BG of the first transistor T1, the body-source voltage Vbs of the first transistor T1 is decreased. As the body-source voltage Vbs of the first transistor T1 is decreased, the threshold voltage Vth of the first transistor T1 is more positive-shifted.

When the threshold voltage Vth of the first transistor T1 becomes 0 V after being positive-shifted, in the state that the threshold voltage Vth of the first transistor T1 is negative-shifted for the initializing period PI, a current does not flow through the first transistor T1 anymore.

The first initializing voltage VREF and the second driving voltage ELVSS may be transmitted to a first electrode and a second electrode of the first capacitor Cst, respectively.

In the state that the current does not flow through the first transistor T1 any more, the voltage of the lower gate electrode BG of the first transistor T1 and the second driving voltage ELVSS may be transmitted to the first electrode and the second electrode of the second capacitor Cth, respectively.

The threshold voltage Vth of the first transistor T1 may be set to 0 V through the initializing period PI and the compensating period PC. In other words, the threshold voltage Vth of the first transistor T1 may be compensated.

Meanwhile, the voltage, that is, the body voltage of the lower gate electrode BG of the first transistor T1 is stored in the second capacitor Cth.

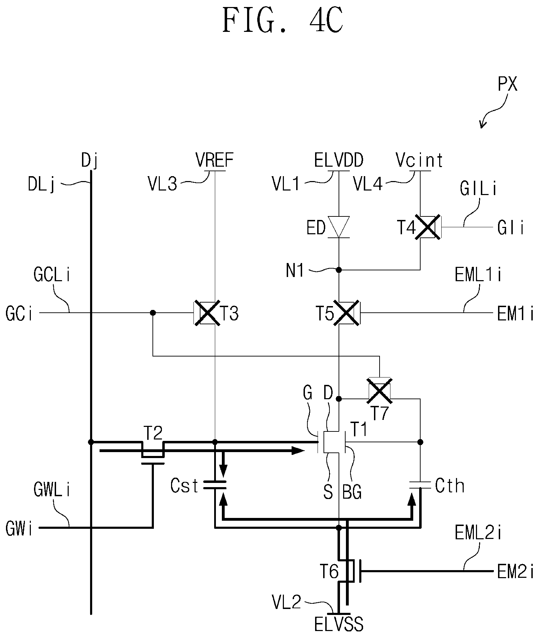

Referring to FIGS. 3 and 4C, each of the second light emitting signal EM2i and the first scan signal GWi is in an active level (for example, a high level), and each of the first light emitting signal EM1i, the second scan signal GCi, and the third scan signal Gli is in an inactive level (for example, a low level), for a write period PW.

During the high level of the second light emitting signal EM2i, and the first scan signal GWi, the second and sixth transistors T2, and T6 are turned on.

Accordingly, for the write period PW, the data signal Dj received through the data line DLj is transmitted to the gate electrode G of the first transistor T1 and the first electrode of the first capacitor Cst through the second transistor T2. In addition, for the write period PW, the second driving voltage ELVSS may be transmitted to the second electrode of the first capacitor Cst and the second electrode of the second capacitor Cth.

In other words, for the write period PW, the data signal Dj may be transmitted to the first electrode of the first capacitor Cst.

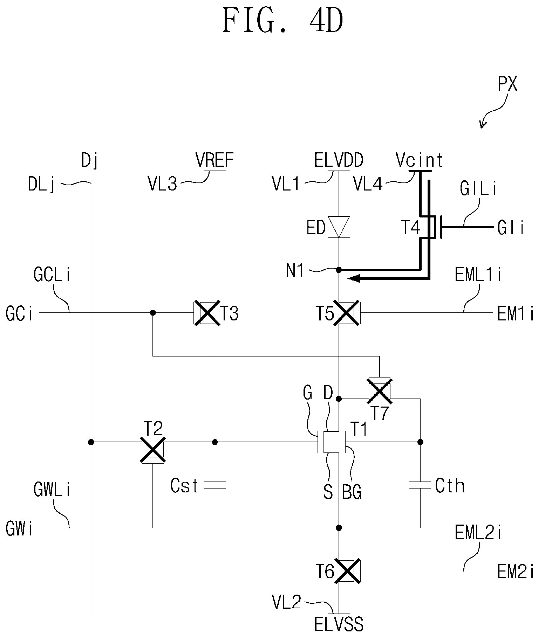

Referring to FIGS. 3 and 4D, the third scan signal Gli is in an active level (for example, a high level), and each of the first light emitting signal EM1i, the second light emitting signal EM2i, the first scan signal GWi, and the second scan signal GCj is in an inactive level (for example, a low level), for a light emitting element initializing period PEI.

During the high level of the third scan signal Gli, the fourth transistor T4 is turned on.

The second initializing voltage Vcint from the fourth driving voltage line VL4 may be transmitted to the cathode of the light emitting element ED through the fourth transistor T4.

Accordingly, for the light emitting element initializing period PEI, the cathode of the light emitting element ED may be initialized to the second initializing voltage Vcint.

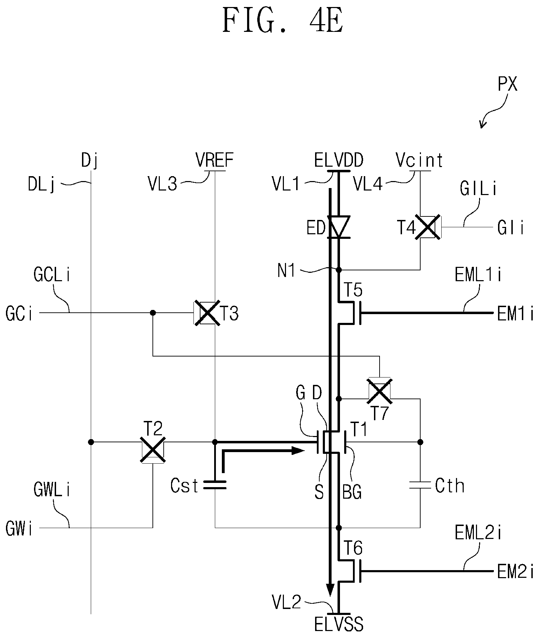

Referring to FIGS. 3 and 4E, each of the first light emitting signal EM1i and the second light emitting signal EM2i is in an active level (for example, a high level), and each of the first scan signal GWi, the second scan signal GCi, and the third scan signal Gli is in an inactive level (for example, a low level), for a light emitting period PE.

During the high level of the first light emitting signal EM1i, and the second light emitting signal EM2i, transistors T5 and T6 are turned on.

Meanwhile, when a voltage corresponding to the data signal Dj stored in the first capacitor Cst is transmitted to the gate electrode G of the first transistor T1, a current path may be formed between the first driving voltage line VL1 and the second driving voltage line VL2 through the light emitting element ED, the fifth, first, and sixth transistors T5, T1, and T6.

Accordingly, a current corresponding to the data signal Dj flows through the light emitting element ED, and the light emitting element ED emits light for the light emitting period PE.

The characteristic of the light emitting element ED in the pixel PX may be changed when the light emitting element ED operates for a longer time. A current (hereinafter, referred to as "Ids") flows between the first electrode D and the second electrode S of the first transistor T1, depending on a gate-source voltage (hereinafter, referred to as "Vgs") of the first transistor T1. When, the light emitting element ED is connected to the second electrode S of the first transistor T1, the change in characteristic of the light emitting element ED changes the gate-source voltage (Vgs) of the first transistor T1 to exert an influence on the current (Ids) of the first transistor T1.

As described above, the light emitting element ED in the pixel PX is connected to the first electrode D of the first transistor T1 through the fifth transistor T5. Accordingly, the change in characteristic, which results from the deterioration of the light emitting element ED, is not transferred to the first transistor T1. Accordingly, degradation of the display quality due to the deterioration of the light emitting element ED may be prevented or reduced.

The threshold voltage Vth of the first transistor T1 may be set to 0 V for the initializing period PI (refer to FIG. 3) and the compensating period PC. In other words, the threshold voltage Vth of the first transistor T1 may be uniformly set in each of the plurality of pixels PX (refer to FIG. 1). Accordingly, degradation of the display quality due to the difference in the threshold voltage Vth of the first transistor T1 in each of the plurality of pixels PX (refer to FIG. 1) may be prevented or reduced.

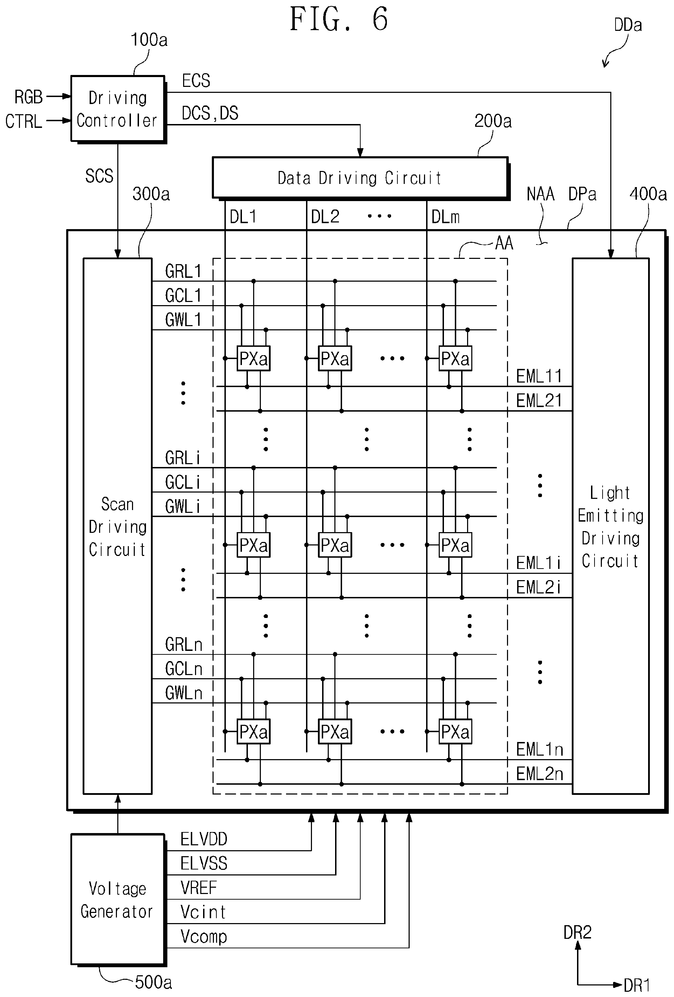

FIG. 6 is a block diagram of an electronic device DDa according to some embodiments of the present disclosure.

Referring to FIG. 6, the electronic device DDa includes a display panel DPa, a driving controller 100a, a data driving circuit 200a, a scan driving circuit 300a, a light emitting driving circuit 400a, and a voltage generator 500a.

In this specification, the same reference numerals will be assigned to components, which are the same as those of the electronic device DD illustrated in FIG. 1, among components of the electronic device DDa in FIG. 6.

The driving controller 100a receives the image signal RGB and the control signal CTRL. The driving controller 100a transforms the image signal RGB into the image data signal DS and output a transform result. The driving controller 100a outputs the scan control signal SCS, the data control signal DCS, and the light emitting control signal ECS.

The data driving circuit 200a receives the data control signal DCS and the image data signal DS from the driving controller 100a. The data driving circuit 200a transforms the image data signal DS into data signals, and outputs the data signals to the plurality of data lines DL1 to DLm to be described later.

The scan driving circuit 300a receives the scan control signal SCS from the driving controller 100a. In addition, the scan driving circuit 300a may output scan signals to the first scan lines GWL1 to GWLn, the second scan lines GCL1 to GCLn, and the third scan lines GRL1 to GRLn, in response to the scan control signal SCS.

The light emitting driving circuit 400a receives the light emitting control signal ECS from the driving controller 100a. The light emitting driving circuit 400a may output light emitting signals to the first light emitting lines EML11 to EML1n, and the second light emitting lines EML21 to EML2n, in response to the light emitting control signal ECS.

The voltage generator 500a generates voltages necessary for an operation of the display panel DPa. According to some embodiments, the voltage generator 500a may generate the first driving voltage ELVDD, the second driving voltage ELVSS, the first initializing voltage VREF, the second initializing voltage Vcint, and a compensating voltage (Vcomp) for the operation of the display panel Dpa in this embodiment.

The display panel DPa may include the first scan lines GWL1 to GWLn, the second scan lines GCL1 to GCLn, the third scan lines GRL1 to GRLn, the first light emitting lines EML11 to EML1n, the second light emitting lines EML21 to EML2n, the data lines DL1 to DLm, and a plurality of pixels PXa.

The display panel DPa includes the active region AA and the non-active region NAA. According to some embodiments, the pixels PXa may be located in the active region AA of the display panel DPa, and the scan driving circuit 300a and the light emitting driving circuit 400a may be located in the non-active region NAA of the display panel DPa.

According to some embodiments, the scan driving circuit 300a is arranged to be adjacent to the first side of the active region AA. The first scan lines GWL1 to GWLn, the second scan lines GCL1 to GCLn, and the third scan lines GRL1 to GRLn extend in the first direction DR1 from the scan driving circuit 300a. The light emitting driving circuit 400a is arranged to be adjacent to the second side of the active region AA. The first light emitting lines EML11 to EML1n, and the second light emitting lines EML21 to EML2n extend in a direction opposite to the first direction DR1 from the light emitting driving circuit 400a.

The first scan lines GWL1 to GWLn, the second scan lines GCL1 to GCLn, the third scan lines GRL1 to GRLn, the first light emitting lines EML11 to EML1n, and the second light emitting lines EML21 to EML2n are spaced apart from each other in the second direction DR2. The data lines DL1 to DLm extend in the direction opposite to the second direction DR2 from the data driving circuit 200a, and may be arranged to be spaced apart from each other in the first direction DR1.

According to some embodiments as illustrated in FIG. 6, the scan driving circuit 300a and the light emitting driving circuit 400a are arranged to face each other while the pixels PXa are interposed between the scan driving circuit 300a and the light emitting driving circuit 400a. However, embodiments according to the present disclosure are not limited thereto. For example, the scan driving circuit 300a and the light emitting driving circuit 400a may be adjacent to each other in the non-active region NAA of the display panel DP. According to some embodiments, the scan driving circuit 300a and the light emitting driving circuit 400a may be integrally implemented in the form of one circuit.

The plurality of pixels PXa are electrically connected to the first scan lines GWL1 to GWLn, the second scan lines GCL1 to GCLn, the third scan lines GRL1 to GRLn, the first light emitting lines EML11 to EML1n, the second light emitting lines EML21 to EML2n, and the data lines DL1 to DLm.

Each of the plurality of pixels PXa may be electrically connected to three scan lines and two light emitting lines. For example, as illustrated in FIG. 6, the pixels PXa in the first row may be connected to the first scan line GWL1, the second scan line GCL1, the third scan line GRL1, the first light emitting line EML11, and the second light emitting line EML21. In addition, the pixels PXa in the i-th row may be connected to the first scan line GWLi, the second scan line GCLi, the third scan line GRLi, the first light emitting line EML1i, and the second light emitting line EML2i. In addition, pixels PXa in an n-th row may be connected to the first scan line GWLn, the second scan line GCLn, the third scan line GRLn, the first light emitting line EML1n, and the second light emitting line EML2n.

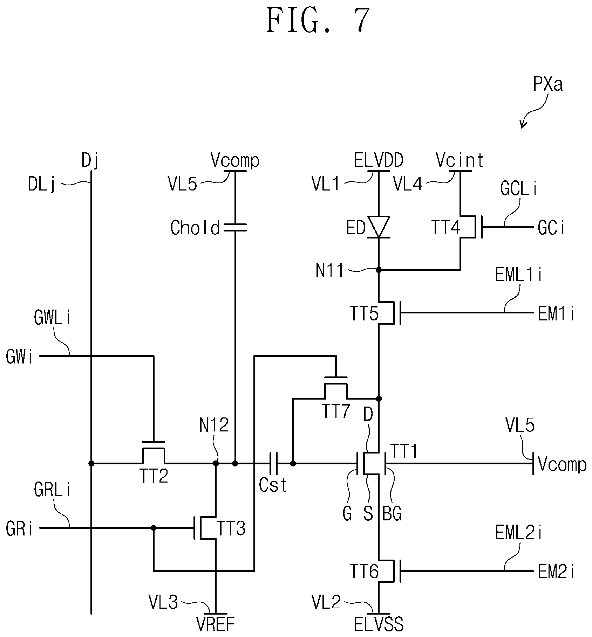

Each of the plurality of pixels PXa may include the light emitting element ED (refer to FIG. 7) and a plurality of transistors TT1 to TT7 (refer to FIG. 7) to control a light emitting operation of the light emitting element ED. The scan driving circuit 300a and the light emitting driving circuit 400a may include transistors formed through the same process as processes for the plurality of transistors TT1 to TT7.

FIG. 7 is a circuit diagram of a pixel PXa according to some embodiments of the present disclosure. Although FIG. 7 illustrates various components in a pixel PXa according to some embodiments, embodiments according to the present disclosure are not limited thereto, and according to various embodiments, the pixel PXa may include additional components or fewer components without departing from the scope of embodiments according to the present disclosure.

FIG. 7 illustrates the circuit diagram of the pixel PXa connected to the j-th data line DLj of the data lines DL1 to DLm illustrated in FIG. 6, the first scan line GWLi of the first scan lines GWL1 to GWLn, the second scan line GCLi of the second scan lines GCL1 to GCLn, the third scan line GRLi of the third scan lines GRL1 to GRLn, the first light emitting line EML1i of the first light emitting lines EML11 to EML1n, and the second light emitting line EML2i of the second light emitting lines EML21 to EML2n, by way of example.

Each of the pixels PXa illustrated in FIG. 6 may have the same circuit configuration as the pixel PXa illustrated in FIG. 7.

Referring to FIG. 7, the pixel PXa of the electronic device according to some embodiments includes at least one light emitting element ED, the first to seventh transistors TT1, TT2, TT3, TT4, TT5, TT6, and TT7, the first capacitor Cst, and a second capacitor Chold.

According to some embodiments, the light emitting element ED may be a light emitting diode. In the following description according to some embodiments, one pixel PXa includes one light emitting element ED by way of example.

According to some embodiments, each of the first to seventh transistors TT1 to TT7 may be an N-type transistor including a semiconductor layer including an oxide semiconductor. However, embodiments according to the present disclosure are not limited thereto. For example, at least one of the first to seventh transistors TT1 to TT7 may be a P-type transistor having a low-temperature polycrystalline silicon (LTPS) semiconductor layer. In addition, according to the present disclosure, the circuit configuration of the pixel PXa is not limited to that of FIG. 7, but may be modified.

The first scan line GWLi, the second scan line GCLi, and the third scan line GRLi transmit the first scan signal GWi, the second scan signal GCi, and the third scan signal GRi provided from the scan driving circuit 300a (refer to FIG. 6).

The first light emitting line EML1i and the second light emitting line EML2i may transmit the first light emitting signal EM1i and the second light emitting signal EM2i provided from the light emitting driving circuit 400a (refer to FIG. 6).

The data line DLj transmits the data signal Dj provided from the data driving circuit 200a (refer to FIG. 6). The data signal Dj may have a voltage level corresponding to the image signal RGB input to the electronic device DDa (refer to FIG. 6). First to fifth driving voltage lines VL1, VL2, VL3, VL4, and VL5 may transmit the first driving voltage ELVDD, the second driving voltage ELVSS, the first initializing voltage VREF, the second initializing voltage Vcint, and a compensating voltage (Vcomp) respectively.

The light emitting element ED is connected between the first driving voltage line VL1 and the first node N11. In other words, the light emitting element ED has an anode connected to the first driving voltage line VL1 and a cathode connected to the first node N11.

The first transistor TT1 includes the first electrode D, the second electrode S, the gate electrode G, and the lower gate electrode BG. The lower gate electrode BG may be referred to as a body electrode.

The lower gate electrode BG of the first transistor TT1 is connected to the fifth driving voltage line VL5.

The second transistor TT2 is connected between the data line DLj and the second node N12, and includes a gate electrode connected to the first scan line GWLi.

The third transistor TT3 is connected between the second node N12 and the third driving voltage line VL3, and includes a gate electrode connected to the third scan line GRLi.

The fourth transistor TT4 is connected between the fourth driving voltage line VL4 and the first node N11, and includes a gate electrode connected to the second scan line GCLi.

The fifth transistor TT5 is connected between the first node N11 and the first electrode D of the first transistor TT1, and includes a gate electrode connected to the first light emitting line EML1i.

The sixth transistor TT6 is connected between the second electrode S of the first transistor TT1 and the second driving voltage line VL2, and includes a gate electrode connected to the second light emitting line EML2i.

The seventh transistor TT7 is connected between the first electrode D of the first transistor TT1 and the gate electrode G of the first transistor TT1, and includes a gate electrode connected to the third scan line GRLi.

The first capacitor Cst is connected between the second node N12 and the gate electrode G of the first transistor TT1.

The second capacitor Chold is connected between the fifth driving voltage line VL5 and the second node N12.

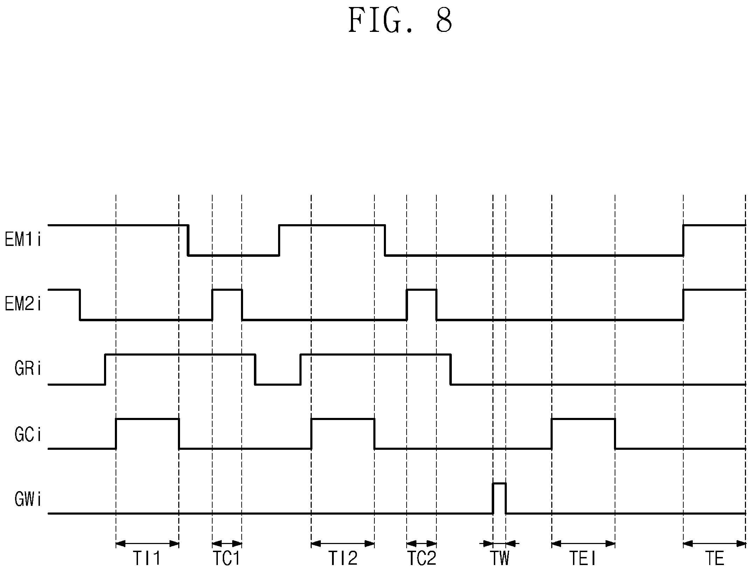

FIG. 8 is a timing diagram illustrating the operation of the pixel PXa according to some embodiments of the present disclosure.

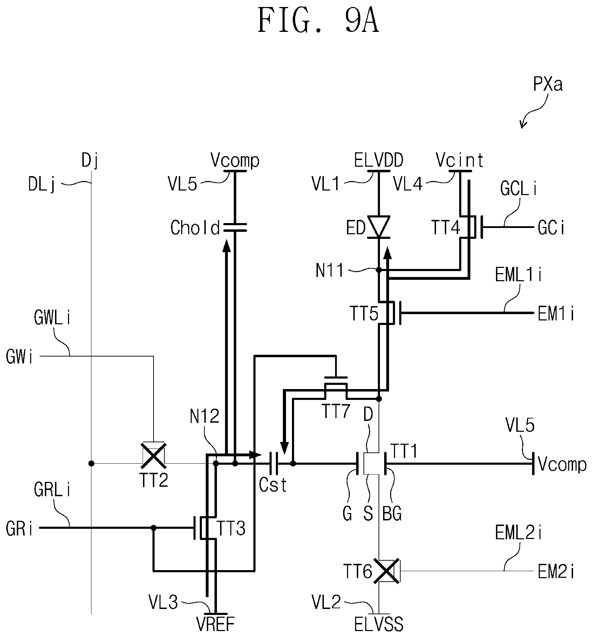

FIGS. 9A to 9E are circuit diagrams illustrating the operation of the pixel PXa according to some embodiments of the present disclosure.

Referring to FIGS. 8 and 9A, each of the first light emitting signal EM1i, the second scan signal GCi, and the third scan signal GRi is in an active level (for example, a high level), and each of the second light emitting signal EM2i and the first scan signal GWi is in an inactive level (for example, a low level), for a first initializing period TI1.

During the high level of the first light emitting signal EM1i, the second scan signal GCi, and the third scan signal GRi, the third, fourth, fifth, and seventh transistors TT3, TT4, TT5, and TT7 are turned on.

Accordingly, for the first initializing period TI1, the first initializing voltage VREF is transmitted to the second node N12, that is, the first electrode of the first capacitor Cst and a first electrode of the second capacitor Chold, through the third transistor TT3. In addition, for the first initializing period TI1, the second initializing voltage Vcint is transmitted to the gate electrode G of the first transistor TT1 and the second electrode of the first capacitor Cst, through the fourth, fifth, and seventh transistors TT4, TT5, and TT7. In other words, for the first initializing period TI1, the second initializing voltage Vcint may be transmitted to the gate electrode G of the first transistor TT1, and the first initializing voltage VREF may be transmitted to the second node N12. The first initializing period TI1 may be an initializing period for initializing the gate electrode G of the first transistor TT1 and the second node N12 to a specific voltage. According to some embodiments, the compensating voltage (Vcomp) is applied to the lower gate electrode BG of the first transistor TT1 and the second electrode of the second capacitor Chold.

Each of the second light emitting signal EM2i and the third scan signal GRi is in an active level (for example, a high level), and each of the first light emitting signal EM1i, the first scan signal GWi, and the second scan signal GCi is in an inactive level (for example, a low level), for the first compensating period TC1.

During the high level of the second light emitting signal EM2i, and the third scan signal GRi, the third, sixth, and seventh transistors TT3, TT6, and TT7 are turned on.

Therefore, for the first compensating period TC1, the first initializing voltage VREF is transmitted to the second node N12, that is, the first electrode of the first capacitor Cst, and the first electrode of the second capacitor Chold, through the third transistor TT3.

For the first initializing period TI1, when the second initializing voltage Vcint is transmitted to the gate electrode G of the first transistor TT1, the first transistor TT1 is turned on.

As the second light emitting signal EM2i is shifted to be in the high level in the state that the first transistor TT1 is turned on, the sixth transistor TT6 is turned on. Accordingly, a current path may be formed from the gate electrode G of the first transistor TT1 to the second driving voltage line VL2 through the seventh, first, and sixth transistors TT7, TT1, and TT6.

In this case, the gate electrode G of the first transistor TT1 is electrically connected to the first electrode D of the first transistor TT1 to be diode-connected. Accordingly, a voltage applied to the gate electrode G of the first transistor TT1, that is, the second electrode of the first capacitor Cst is increased by the threshold voltage (referred to as 'Vth') of the first transistor TT1. For example, the voltage applied to the second electrode of the first capacitor Cst may be 'ELVSS+Vth'.

The operation of the pixel PXa for the second initializing period TI2 is the same as that of the pixel PXa for the first initializing period TI1 described with reference to FIG. 9A, so the repeated duplication thereof will be omitted.

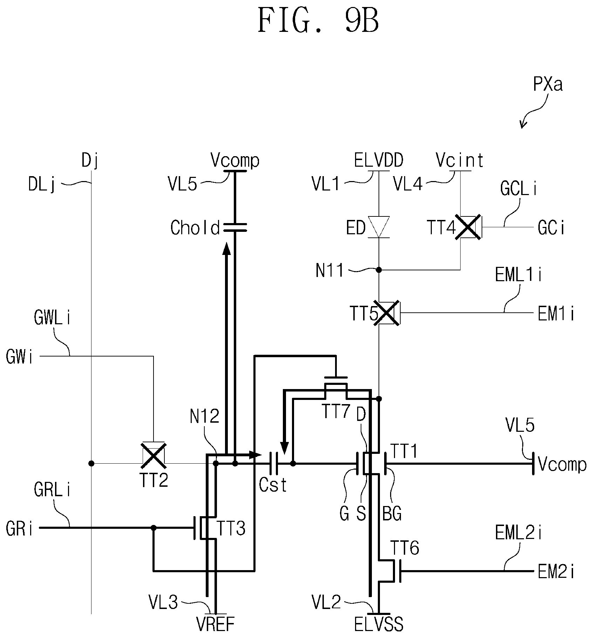

The operation of the pixel PXa for the second compensating period TC2 is the same as that of the pixel PXa for the first compensating period TC1 described with reference to FIG. 9B, so the repeated duplication thereof will be omitted.

As the first initializing period TI1, the first compensating period TC1, and the second initializing period TI2, and the second compensating period TC2 are sequentially repeated, the compensating effect for the threshold voltage Vth of the first transistor TT1 may be increased.

FIG. 8 illustrates that an initializing period is repeated twice and a compensating period is repeated twice. In other words, the initializing period and the compensating period are alternately repeated twice. However, embodiments according to the present disclosure are not limited thereto. At least one initializing period and at least one compensating period can occur more than once.

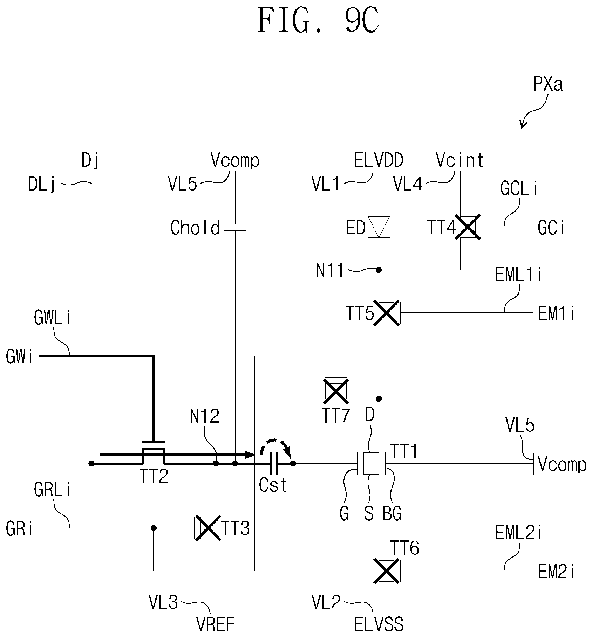

Referring to FIGS. 8 and 9C, the first scan signal GWi is in an active level (for example, a high level), and each of the first light emitting signal EM1i, the second light emitting signal EM2i, the second scan signal GCi and the third scan signal GRi is in an inactive level (for example, a low level), for the write period TW.

During the high level of the first scan signal GWi, the second transistor TT2 is turned on.

Accordingly, for the write period TW, the data signal Dj received through the data line DLj is transmitted to the second node N12 through the second transistor TT2.

When a voltage of the first electrode of the first capacitor Cst is increased by a voltage of the data signal Dj from the first initializing voltage VREF, even a voltage of the second electrode of the first capacitor Cst is increased by the voltage of the data signal Dj from 'ELVSS+Vth'.

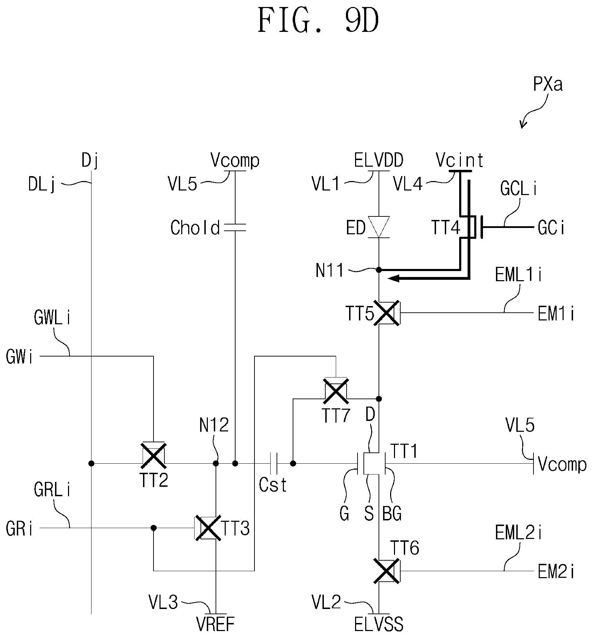

Referring to FIGS. 8 and 9D, the second scan signal GCi is in an active level (for example, a high level), and each of the first light emitting signal EM1i, the second light emitting signal EM2i, the first scan signal GWi, and the third scan signal GRi is in an inactive level (for example, a low level), for a light emitting element initializing period TEI.

During the high level of the second scan signal GCi, the fourth transistor TT4 is turned on.

The second initializing voltage Vcint from the fourth driving voltage line VL4 may be transmitted to the cathode of the light emitting element ED through the fourth transistor TT4.

Accordingly, for the light emitting element initializing period TEI, the cathode of the light emitting element ED may be initialized to the second initializing voltage Vcint.

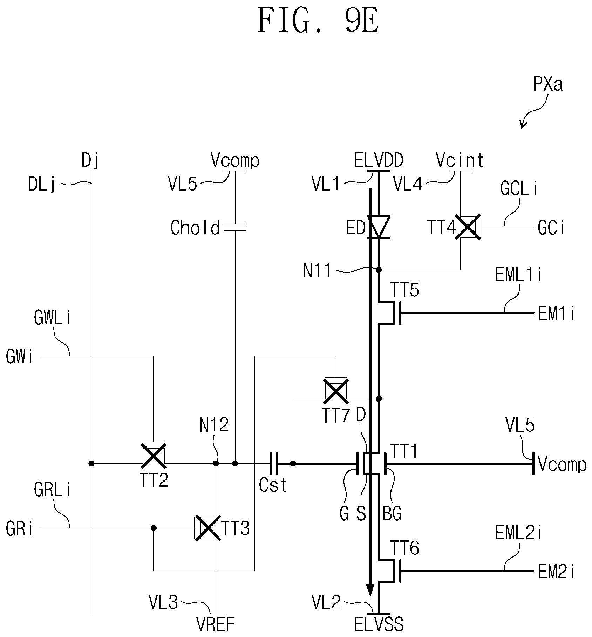

Referring to FIGS. 8 and 9E, each of the first light emitting signal EM1i and the second light emitting signal EM2i is in an active level (for example, a high level), and each of the first scan signal GWi, the second scan signal GCi, and the third scan signal GRi is in an inactive level (for example, a low level), for a light emitting period TE.

During the high level of the first light emitting signal EM1i, and the second light emitting signal EM2i, the fifth and sixth transistors TT5 and TT6 are turned on.

Meanwhile, as the voltage of the second electrode of the first capacitor Cst, that is, the voltage of the gate electrode G of the first transistor TT1 is increased by a voltage corresponding to the data signal Dj, the first transistor TT1 is turned on.

Accordingly, a current path may be formed between the first driving voltage line VL1 and the second driving voltage line VL2 through the light emitting element ED, the fifth, first, and sixth transistors TT5, TT1, and TT6.

Accordingly, a current corresponding to the data signal Dj flows through the light emitting element ED, and the light emitting element ED emits light for the light emitting period TE.

The characteristic of the light emitting element ED in the pixel PXa may be changed when the light emitting element ED operates for a longer time. A current (hereinafter, referred to as "Ids") flows between the first electrode D and the second electrode S of the first transistor TT1, depending on a gate-source voltage (hereinafter, referred to as "Vgs") of the first transistor TT1. When, the light emitting element ED is connected to the second electrode S of the first transistor TT1, the change in characteristic of the light emitting element ED changes the gate-source voltage (Vgs) of the first transistor TT1 to exert an influence on the current (Ids) of the first transistor TT1.

As described above, the light emitting element ED in the pixel PXa is connected to the first electrode D of the first transistor TT1 through the fifth transistor TT5. Accordingly, the change in characteristic, which results from the deterioration of the light emitting element ED, is not transferred to the first transistor TT1. Therefore, degradation of the display quality due to the deterioration of the light emitting element ED may be prevented or reduced.

In addition, for the initializing periods TI1 and TI2 and the compensating periods TC1 and TC2, the voltage of the second electrode of the first capacitor Cst may be increased by the threshold voltage Vth of the first transistor TT1. Accordingly, the current (Ids) flowing between the first electrode D and the second electrode S of the first transistor TT1 may be determined regardless of the threshold voltage Vth of the first transistor TT1. Accordingly, degradation of the display quality due to the difference in the threshold voltages Vth of the first transistors TT1 in the plurality of pixels PXa (refer to FIG. 6) may be prevented or reduced.

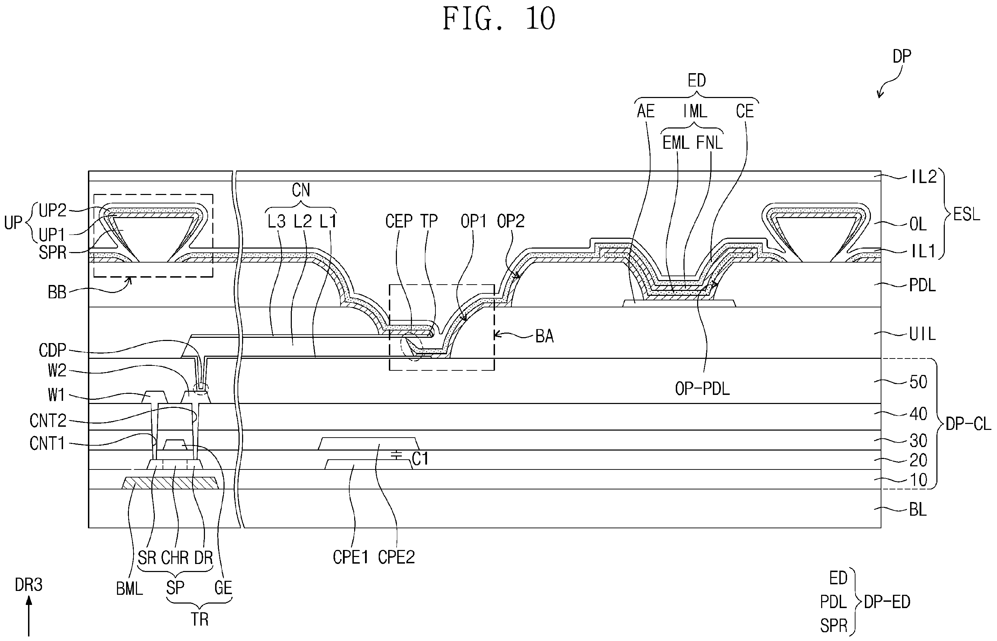

FIG. 10 is a cross-sectional view of a display panel DP according to some embodiments of the present disclosure.

Referring to FIG. 10, the display panel DP includes a base layer BL, a circuit element layer DP-CL located on the base layer BL, an upper insulating layer UIL, a connection wire CN, a display element layer DP-ED, and an encapsulating layer ESL.

In FIG. 10, one transistor TR and one capacitor C1 are illustrated in the pixel PX (refer to FIG. 2). The transistor TR corresponds to a transistor connected to the light emitting element ED through the connection wire CN, that is, a transistor connected to a node (for example, the first node N1 of FIG. 2) corresponding to the cathode CE of the light emitting element ED. Specifically, the transistor TR may correspond to the fifth transistor T5 of FIG. 2 or the fifth transistor TT5 of FIG. 7. Meanwhile, according to some embodiments, other transistors T1, T2, T3, T4, T6, T7, TT1, TT2, TT3, TT4, TT6, and TT7 constituting the pixel PX or pixel PXa may have the same structure as that of the transistor TR illustrated in FIG. 10. However, this is provided only for the illustrative purpose. Other transistors T1, T2, T3, T4, T6, T7, TT1, TT2, TT3, TT4, TT6, and TT7 constituting the pixel PX or the pixel PXa may have a structure different from that of the transistor TR, and embodiments according to the present disclosure are not limited thereto.

A lower conductive layer BML may be overlapped with the transistor TR, and may be covered by a first insulating layer 10. At least one of an inorganic barrier layer or a buffer layer may be further located between the lower conductive layer BML and the base layer BL.

According to some embodiments, the lower conductive layer BML may be connected to a source of the transistor TR through a source electrode pattern W1. In this case, the lower conductive layer BML may be synchronized with the source of the transistor TR. However, this is provided only for the illustrated purpose. For example, the lower conductive layer BML may be connected to a gate of the transistor TR to be synchronized with the gate. Alternatively, the lower conductive layer BML may be connected to another electrode to receive a constant voltage or a pulse signal independently. Alternatively, the lower conductive layer BML may be provided in the form isolated from another conductive pattern. According to some embodiments of the present disclosure, the lower conductive layer BML may be provided in various forms, and is not limited to any one embodiment.

The transistor TR may be located on the first insulating layer 10. The transistor TR may include a semiconductor pattern SP and a gate electrode GE. The semiconductor pattern SP may be located on the first insulating layer 10. The semiconductor pattern SP may include a source region SR, a drain region DR, and a channel region CHR divided depending on a conductivity degree.

According to some embodiments, the display panel may further include a source electrode pattern W1 and a drain electrode pattern W2, which are additionally provided, connected to the source region SR and the drain region DR, respectively. In detail, the source electrode pattern W1 and the drain electrode pattern W2, which are additionally provided, may be formed integrally with one of lines constituting the pixel PX (refer to FIG. 2), and embodiments according to the present disclosure are not limited thereto.

A second insulating layer 20 may be overlapped with the plurality of pixels, in common, to cover the semiconductor pattern SP. The gate electrode GE may be located on the second insulating layer 20. The gate electrode GE may correspond to a gate of the transistor TR.

A third insulating layer 30 may be located on the gate electrode GE, and a fourth insulating layer 40 may be located on the third insulating layer 30. A plurality of conductive patterns may include a first capacitor electrode CPE1 and a second capacitor electrode CPE2.

The first capacitor electrode CPE1 and the second capacitor electrode CPE2 constitute the capacitor C1. The first capacitor electrode CPE1 and the second capacitor electrode CPE2 may be spaced apart from each other while interposing the second insulating layer 20 between the first capacitor electrode CPE1 and the second capacitor electrode CPE2.

According to some embodiments of the present disclosure, the first capacitor electrode CPE1 and the semiconductor pattern SP may have an integral form. Alternatively, the second capacitor electrode CPE2 and the gate electrode GE may have an integral form.

According to some embodiments, the capacitor C1 may correspond to the first capacitor Cst illustrated in FIG. 2.

A fourth insulating layer 40 may be located on the third insulating layer 30. A source electrode pattern W1 and a drain electrode pattern W2 may be located on the fourth insulating layer 40. The source electrode pattern W1 may be connected to the source region SR of the transistor TR through a first contact hole CNT1, and the source electrode pattern W1 and the source region SR of the transistor TR may serve as the source of the transistor TR. The drain electrode pattern W2 may be connected to the drain region DR of the transistor TR through a second contact hole CNT2, and the drain electrode pattern W2 and the drain region DR of the semiconductor pattern SP may serve as the drain of the transistor TR. A fifth insulating layer 50 may be located on the source electrode pattern W1 and the drain electrode pattern W2.

The connection wire CN may be located on the fifth insulating layer 50. The connection wire CN may electrically connect the transistor TR to the light emitting element ED. The connection wire CN may be a connection node to connect the transistor TR to the light emitting element ED. In other words, the connection wire CN may correspond to the first node N1 illustrated in FIG. 2 or the first node N11 illustrated in FIG. 7. Meanwhile, this is provided only for the illustrative purpose. For example, the connection wire CN may be defined as a connection node connected with various components among components constituting the pixel PX depending on the design of the pixel PX, as long as the connection wire CN is connected to the light emitting element ED.

An upper insulating layer UIL may be located on the connection wire CN. The upper insulating layer UIL may be located on the fifth insulating layer 50 to cover the connection wire CN. The upper insulating layer UIL may be an organic layer. For example, the upper insulating layer UIL may include a general purpose polymer, such as Benzocyclobutene (BCB), polyimide, Hexamethyldisiloxane (HMDSO), Polymethylmethacrylate (PMMA) or Polystyrene (PS), a polymer derivative having a phenolic group, an acrylic polymer, an imide-based polymer, an acryl ether polymer, an amide-based polymer, a fluorine-based polymer, a p-xylene-based polymer, a vinyl alcohol-based polymer, and a blend thereof.

The upper insulating layer UIL may include an opening part to expose at least a portion of the connection wire CN. The connection wire CN may be electrically connected to the light emitting element ED through the exposed portion from the upper insulating layer UIL. In other words, the connection wire CN may electrically connect the transistor TR and the light emitting element ED. The details thereof will be described later. Meanwhile, according to some embodiments of the present disclosure, the upper insulating layer UIL may be omitted from the display panel DP, or a plurality of upper insulating layers UIL may be provided. However, embodiments according to the present disclosure are not limited to any one embodiment.

A display element layer DP-ED may be located on the upper insulating layer UIL. The display element layer DP-ED may include a pixel defining layer PDL, the light emitting element ED, and a separator SPR. The light emitting element ED may include an anode AE, an intermediate layer IML, and a cathode CE.

According to some embodiments, the anode AE may be located on the upper insulating layer UIL. The anode AE may be a semi-transparent electrode, a transmission electrode, or a reflective electrode. According to some embodiments, the electrode AE may include a reflective layer, which is formed of silver (Ag), magnesium (Mg), aluminum (Al), platinum (Pt), palladium (Pd), gold (Au), nickel (Ni), neodymium (Nd), iridium (Ir), chromium (Cr), or a compound thereof, and a transparent electrode layer or a semi-transparent electrode layer formed on the reflective layer. The transparent electrode layer or a semi-transparent electrode layer may include at least one selected from the group consisting of indium tin oxide (ITO), indium zinc oxide (IZO), indium gallium zinc oxide (IGZO), zinc oxide (ZnO) or indium oxide (In₂O₃), and aluminum doped zinc oxide (AZO). For example, the anode AE may include a stack structure of ITO/Ag/ITO. The anode AE may be connected to a first driving voltage line VL1 (refer to FIG. 2) to receive the first driving voltage (ELVDD; refer to FIG. 2).

A light emitting opening part OP-PDL may be defined in the pixel defining layer PDL to expose at least a portion of the anode AE. A plurality of light emitting opening parts OP-PDL may be provided to correspond to each light emitting element ED. All components of the light emitting element ED may be overlapped with each other in the light emitting opening part OP-PDL. The light emitting opening part OP-PDL may actually be a region to express light emitted from the light emitting element ED.

An intermediate layer IML may be interposed between the anode AE and the cathode CE. The intermediate layer IML may include a light emitting layer EML and a functional layer FNL. The light emitting element ED may include intermediate layers IML in various structures, and embodiments according to the present disclosure are not limited to any one embodiment. For example, the functional layer FNL may be provided in the form of a plurality of layers, or may be provided at least two layers spaced apart from each other while interposing the light emitting layer EML between the at least two layers. Alternatively, according to some embodiments, the functional layer FNL may be omitted. Although FIG. 10 illustrates that the light emitting layer EML and the functional layer FNL have mutually different shapes, embodiments according to the present disclosure are not limited thereto. For example, the light emitting layer EML and the functional layer FNL may be arranged in the same shape, when viewed in a plan view.

The functional layer FNL may be interposed between the anode AE and the cathode CE. Specifically, the functional layer FNL may be interposed between the anode AE and the light emitting layer EML, or may be interposed between the cathode CE and the light emitting layer EML. Alternatively, the functional layer FNL may be interposed between the anode AE and the light emitting layer EML and interposed between the cathode CE and the light emitting layer EML. According to some embodiments, it is illustrated that the light emitting layer EML is inserted into the functional layer FNL. However, this is provided only for the illustrative purpose. For example, the functional layer FNL may include a layer interposed between the light emitting layer EML and the anode AE and/or a layer interposed between the light emitting layer EML and the cathode CE. Each layer may be provided in the form of a plurality of layers. However, embodiments according to the present disclosure are not limited to any one embodiment. The functional layer FNL may include a hole control layer and an electron control layer. At least a portion of the hole control layer may be interposed between the anode AE and the light emitting layer EML, and at least a portion of the electron control layer may be interposed between the light emitting layer EML and the cathode CE.

The cathode CE may be located on the intermediate layer IML. The cathode CE may be connected to the connection wire CN and may be electrically connected to the pixel PX, as described above. In other words, the cathode CE may be electrically connected to the transistor TR through the connection wire CN.

As described above, the connection wire CN may include a driving connection part CDP and a light emitting connection part CEP. The driving connection part CDP may be a portion, which is connected to the transistor TR, of the connection wire CN. According to some embodiments, the driving connection part CDP may pass through the fifth insulating layer 50 and be electrically connected to the drain region DR of the semiconductor pattern SP through the drain electrode pattern W2. The light emitting connection part CEP may be a portion, which is connected to the light emitting element ED, of the connection wire CN. The light emitting connection part CEP may be defined in a region exposed from the upper insulating layer UIL, and may be part connected to the cathode CE. In this case, a tip part TP may be defined in the light emitting connection part CEP.

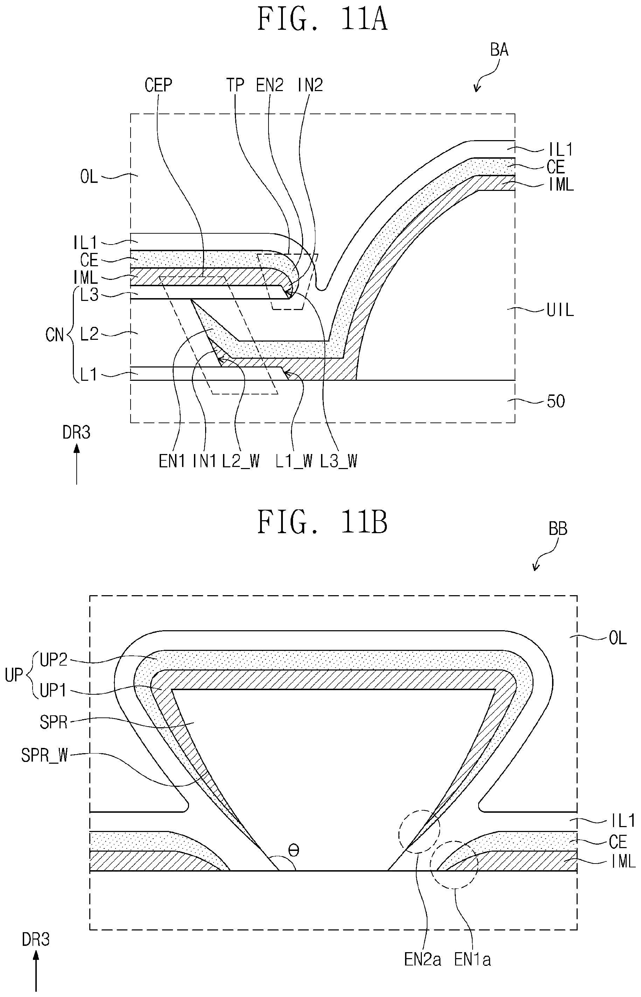

FIG. 11A is an enlarged cross-sectional view according to some embodiments of the present disclosure, in which region BA of FIG. 10 is enlarged.

Referring to FIGS. 10 and 11A, the light emitting connection part CEP of the connection wire CN will be described in more detail. As illustrated in FIGS. 10 and 11A, the connection wire CN may have a triple structure. In detail, the connection wire CN may include a first layer L1, a second layer L2, and a third layer L3 sequentially stacked on each other in a third direction DR3. The second layer L2 may include a material different from a material of the first layer L1. In addition, the second layer L2 may include a material different from a material of the third layer L3. The second layer L2 may have a thickness thicker than a thickness of the first layer L1. In addition, the second layer L2 may have a thickness thicker than the thickness of the third layer L3. The second layer L2 may include a material having a higher conductivity. According to some embodiments, the second layer L2 may include aluminum (Al).

Meanwhile, the first layer L1 may have a material having an etch rate lower than an etch rate of the second layer L2. In other words, the second layer L2 may include a material having higher selectivity over the first layer L1. According to some embodiments, the first layer L1 may include titanium (Ti), and the second layer L2 may include aluminum (Al). In this case, a side surface L1_W of the first layer L1 may be defined outward from a side surface L2_W of the second layer L2. In other words, the light emitting connection part CEP of the connection wire CN may have the form in which the side surface L1_W of the first layer L1 may protrude outward from the side surface L2_W of the second layer L2. In other words, the light emitting connection part CEP of the connection wire CN may have the shape in which the side surface L2_W of the second layer L2 is recessed inward from the side surface L1_W of the first layer L1.

Meanwhile, the third layer L3 may have a material having an etch rate lower than an etch rate of the second layer L2. In other words, the second layer L2 may include materials having higher selectivity over the third layer L3. According to some embodiments, the third layer L3 may include titanium (Ti), and the second layer L2 may include aluminum (Al). In this case, the side surface L3_W of the third layer L3 may be defined outward from the side surface L2_W of the second layer L2. In other words, the light emitting connection part CEP of the connection wire CN may have the form in which the side surface L3_W of the third layer L3 protrudes outward from the side surface L2_W of the second layer L2. In other words, the light emitting connection part CEP of the connection wire CN may have an under-cut shape or an overhang structure. The tip part TP of the light emitting connection part CEP may be defined by a portion, which protrudes from the second layer L2, of the third layer L3.

The upper insulating layer UIL and the pixel defining layer PDL may expose at least a portion of the tip part TP and at least a portion of the side surface L2_W. In detail, a first opening part OP1, which exposes one side of the connection wire CN, may be defined in the upper insulating layer UIL, and a second opening part OP2 overlapped with the first opening part OP1 may be defined in the pixel defining layer PDL. A planar area of the second opening part OP2 may be larger than a planar area of the first opening part OP1. However, embodiments according to the present disclosure are not limited thereto. As long as the at least a portion of the tip part TP and the at least of the side surface L2_W are exposed, the planar area of the second opening part OP2 may be smaller than or equal to the planar area of the first opening part OP1.

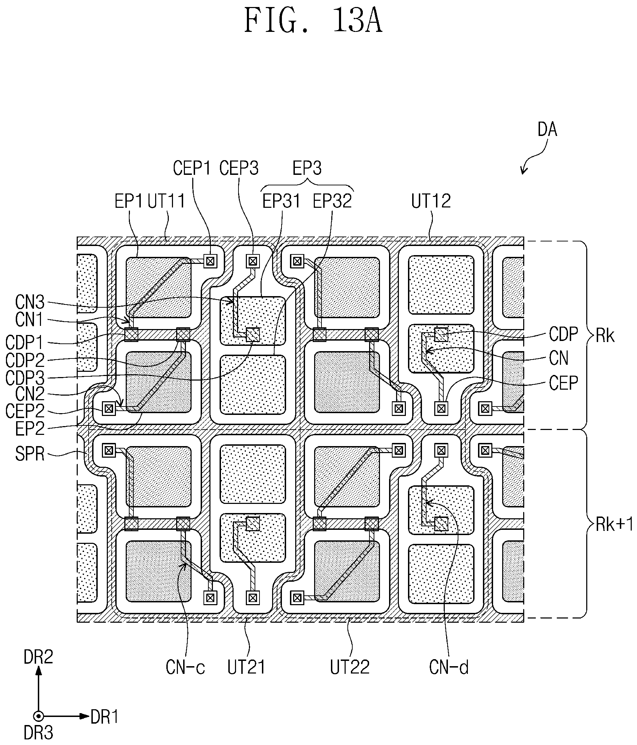

The intermediate layer IML may be located on the pixel defining layer PDL. The intermediate layer IML may be located only on a partial region, which is exposed through the second opening part OP2 of the pixel defining layer PDL, of the upper insulating layer UIL. In addition, the intermediate layer IML may be located only on a partial region, which is exposed through the first opening part OP1 of the upper insulating layer UIL, of the connection wire CN. As illustrated in FIG. 11A, the intermediate layer IML may include a first end portion IN1, which is arranged along the top surface of the fifth insulating layer 50, and a second end portion IN2 which is arranged along a top surface of the connection wire CN and the tip part TP. In other words, when viewed in a cross-sectional view, the intermediate layer IML may have the form in which the intermediate layer IML is partially disconnected based on the tip part TP in a region in which the light emitting connection part CEP is defined. However, when viewed in a plan view, the intermediate layer IML may have an integral form in which the intermediate layer IML is connected inside a region (refer to FIG. 13A) defined as a closed line by the separator SPR.

The cathode CE may be located on the intermediate layer IML. The cathode CE may be located only on a partial region, which is exposed through the second opening part OP2 of the pixel defining layer PDL, of the upper insulating layer UIL. In addition, the cathode CE may be located only on a partial region, which is exposed through the first opening part OP1 of the upper insulating layer UIL, of the connection wire CN. As illustrated in FIG. 11A, the cathode CE may include a first end portion EN1, which is arranged along the top surface of the fifth insulating layer 50, and a second end portion EN2 which is arranged along a top surface of the connection wire CN and the tip part TP. In other words, when viewed in a cross-sectional view, the cathode CE may have the form in which the cathode CE is partially disconnected based on the tip part TP, in a region in which the light emitting connection part CEP is defined. However, when viewed in a plan view, the cathode CE may have an integral form in which the cathode CE is connected inside a region (refer to FIG. 13A) defined as a closed line by the separator SPR.

Meanwhile, the first end portion EN1 of the cathode CE may be arranged along the side surface of the second layer L2 to make contact with the side surface L2_W of the second layer L2. In detail, based on the difference in deposition angle between the cathode CE and the intermediate layer IML, the cathode CE may be formed to make contact with the side surface L2_W of the second layer L2, which is exposed from the intermediate layer IML through the tip part TP. In other words, the cathode CE may be connected to the connection wire CN without an additional patterning process for the intermediate layer IML, so the light emitting element ED may be electrically connected to the transistor TR through the connection wire CN.

In addition, according to some embodiments, although it is illustrated that the second end portion IN2 of the intermediate layer IML and the second end portion EN2 of the cathode CE cover the side surface L3_W of the third layer L3, this is provided only for the illustrative purposes. At least a portion of the side surface L3_W of the third layer L3 may be exposed from the second end portion IN2 of the intermediate layer IML and the second end portion EN2 of the cathode CE.

According to some embodiments, the display panel DP may include the separator SPR. The separator SPR may be located on the pixel defining layer PDL. According to some embodiments, the cathode CE and the intermediate layer IML may be deposited in common for the plurality of pixels through an open mask. In this case, the cathode CE and the intermediate layer IML may be separated by the separator SPR. As described above, the separator SPR may have a closed line formed with respect to each light emitting part. Accordingly, the cathode CE and the intermediate layer IML may have a separated shape with respect to each light emitting part. In other words, the cathode CE and the intermediate layer IML may be electrically independent between adjacent pixels.

FIG. 11B is an enlarged cross-sectional view according to some embodiments of the present disclosure, in which region BB of FIG. 10 is enlarged.

Hereinafter, the details of the separator SPR will be described with reference to FIGS. 10 and 11B. As illustrated in FIG. 11B, the separator SPR may have an inverse-taper shape. In other words, an angle formed by a side surface SPR_W of the separator SPR with respect to the top surface of the pixel defining layer PDL may be an obtuse angle (θ; a taper angle hereinafter). However, this is provided only for the illustrative purpose. For example, the taper angle (θ) may be set to various angles, as long as the separator SPR electrically isolates the cathode CE for each pixel. In addition, the separator SPR may have a structure the same as that of the tip part TP, but embodiments according to the present disclosure are not limited thereto.

According to some embodiments, the separator SPR may include a material, especially, an organic insulating material, having an insulating property. The separator SPR may include an inorganic insulating material, may have a configuration in which an organic insulating material and an inorganic insulating material are contained at multiple layers, or may include a conductive material according to some embodiments. In other words, the separator SPR may include various materials without limiting the type of a material, as long as the cathode CE is electrically isolates for each pixel.

A dummy layer UP may be located on the separator SPR. The dummy layer UP may include a first dummy layer UP1 located on the separator SPR and a second dummy layer UP2 located on the first dummy layer UP1. The first dummy layer UP1 may be formed in the same process as that of the intermediate layer IML, and may include the same material as that of the intermediate layer IML. The second dummy layer UP2 may be formed in the same process as that of the cathode CE, and may include the same material as that of the cathode CE. In other words, the first dummy layer UP1 and the second dummy layer UP2 may be simultaneously formed in the process in which the intermediate layer IML and the cathode CE are formed. According to some embodiments, the display panel DP may not include the dummy layer UP.

As illustrated in FIG. 11B, according to some embodiments, the cathode CE may include a first end portion EN1a, and the second dummy layer UP2 may include a second end portion EN2a. The first end portion EN1a may be spaced away from the separator SPR and may be positioned on the pixel defining layer PDL. The second end portion EN2a may be separated from the first end portion EN1a and may be positioned on the side surface SPR_W of the separator SPR. However, although FIG. 11B illustrates that the first end portion EN1a is spaced apart from the side surface SPR_W of the separator SPR by a specific distance, embodiments according to the present disclosure are not limited to this. Even the first end portion EN1a may make contact with the side surface SPR_W of the separator SPR as long as the first end portion EN1a forms an open-circuit with the second end portion EN2a. In addition, even if the first end portion EN1a and the second end portion EN2a are connected to each other without the separation therebetween, when portions, which are formed along the side surface SPR_W of the separator SPR, of the first end portion EN1a and the second end portion EN2a have thinner thickness to show a larger electrical resistance such that the cathode CE is electrically isolated between adjacent pixels, the cathode CE may be determined as being separated by the separator SPR.

According to some embodiments, even if an additional patterning processes is absent with respect to the cathode CE or the intermediate layer IML, the cathode CE or the intermediate layer IML may not be formed or formed to have thinner thicknesses on the side surface SPR_W of the separator SPR, such that the cathode CE or the intermediate layer IML is separated in each pixel. In addition, the separator SPR may have various shapes as long as the cathode CE or the intermediate layer IML may be electrically isolated between adjacent pixels. However, embodiments according to the present disclosure are not limited to any one embodiment.

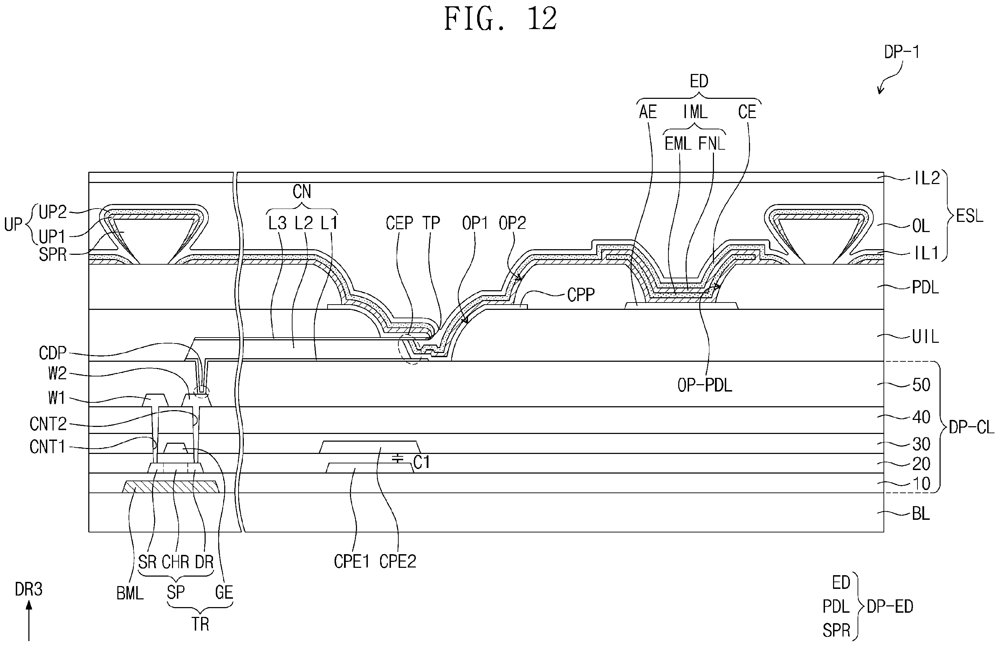

FIG. 12 is a cross-sectional view of a display panel according to some embodiments of the present disclosure. For the easy convenience of explanation, FIG. 12 illustrates a cross-sectional view of a region corresponding to that of FIG. 10. Hereinafter, the same components as components described with reference to FIG. 10 will be assigned with the same reference numerals as those of the components described with reference to FIG. 10, and the duplicated description will be omitted to avoid redundancy.

A display panel DP-1 illustrated in FIG. 12 may further include a capping pattern CPP as compared to the display panel illustrated in FIG. 10. The capping pattern CPP may be located on the upper insulating layer UIL. In addition, the capping pattern CPP may be located only on a partial region, which is exposed through the first opening part OP1 of the upper insulating layer UIL, of the connection wire CN. The capping pattern CPP may be overlapped with the connection wire CN. Specifically, the capping pattern CPP may be overlapped with the light emitting connection part CEP and/or the tip part TP.

In other words, as illustrated in FIG. 12, when viewed in a cross-sectional view, the capping pattern CPP may have the form in which the capping pattern CPP is partially disconnected, based on the tip part TP in a region in which the light emitting connection part CEP is defined. However, when viewed in a plan view, the capping pattern CPP may have an integral form in which the capping pattern CPP is connected inside a region (refer to FIG. 13A) defined as a closed line by the separator SPR. Meanwhile, one end portion, which is partially disconnected, of the capping pattern CPP may make contact with the side surface of the second layer L2 of the connection wire CN, and another end portion of the capping pattern CPP may be located at an upper portion of the third layer L3 of the connection wire CE to cover the tip part TP.

The capping pattern CPP may include a conductive material. Accordingly, the cathode CE may be electrically connected to the connection wire CN through the capping pattern CPP. In other words, the capping pattern CPP make contact with the side surface of the second layer L2 of the connection wire CN and then the cathode CE makes contact with the capping pattern CPP such that all electrical connections are made. As the capping pattern CPP is located relatively outside the second layer L2 of the connection wire CN, and the cathode CE is merely connected to the capping pattern CPP instead of the side surface of the second layer L2, the cathode CE may be electrically connected to the second layer L2. Accordingly, the connection between the connection wire CN and the cathode CE may be more easily made.

In addition, the capping pattern CPP may include a material having lower reactivity than that of the second layer L2 of the connection wire CN. For example, the capping pattern CPP may include copper (Cu), silver (Ag), or a transparent conductive oxide. As the side surface of the second layer L2 of the connection wire CN is protected by the capping pattern CPP having lower reactivity, oxidation of the material included in the second layer L2 may be prevented or reduced. In addition, a silver (Ag) component contained in the layer for the anode AE may be prevented from being reduced to remain as particles such that defects are caused, during an etch process of patterning the anode AE.

According to some embodiments, the capping pattern CPP may be formed through the same process as that of the anode AE and may include the same material as that of the anode AE. However, this is provided only for the illustrative purpose. The capping pattern CPP may be formed in a process different from that of the anode AE, and may include a material different from that of the anode AE. However, embodiments according to the present disclosure are not limited to any one embodiment.

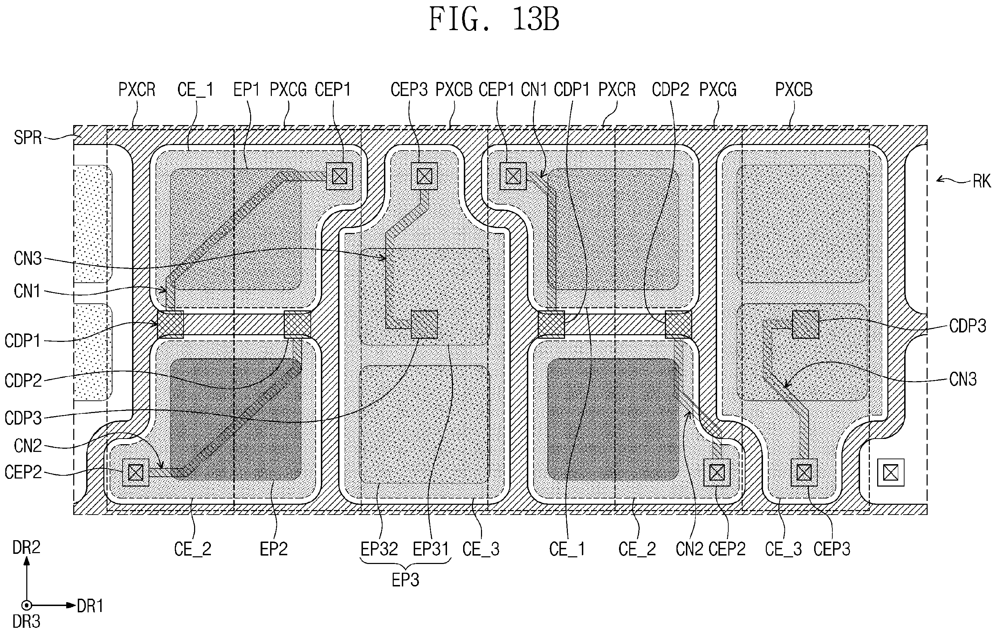

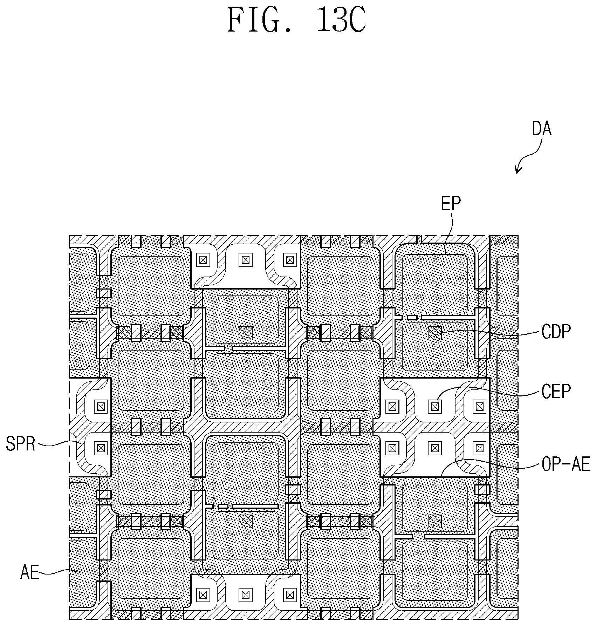

FIGS. 13A to 13C are plan views illustrating an enlarged partial region of a display panel according to some embodiments. FIGS. 13A to 13C may correspond to enlarged plan views of the display panels DP and DP-1 according to some embodiments as described above with reference to FIGS. 10 to 12. FIG. 13A illustrates a total of four light emitting units provided in two rows and two columns, and FIG. 13B illustrates an enlarged partial region illustrated in FIG. 13A. FIG. 13C illustrates components of FIG. 13A by omitting or emphasizing some components of FIG. 13A. Hereinafter, the present disclosure will be described with reference to FIGS. 13A to 13C.

FIG. 13A illustrates the light emitting units UT11, UT12, UT21, and UT22 provided in two rows and two columns. Light emitting parts in a first row Rk include light emitting parts including the light emitting unit UT11 in a first row Rk and a first column and the light emitting unit UT12 in the first row Rk and a second column. Light emitting parts in a second row Rk+1 includes the light emitting unit UT21 in a second row Rk+1and the first column and the light emitting units UT22 in the second row Rk+1 and a second column. FIG. 13B illustrates the light emitting parts in the first row Rk. FIGS 13A to 13C illustrate the separator SPR, the plurality of light emitting parts EP1, EP2, and EP3 connection wires CN1, CN2, and CN3, the anode AE, and the cathode CE, which are provided in regions separated by the separator SPR, among components of the display panel.

As described above, each of the light emitting parts EP1, EP2, and EP3 may correspond to the light emitting opening part OP-PDL (refer to FIG. 10). In other words, each of the light emitting parts EP1, EP2, and EP3 may be regions for emitting light by the light emitting element, and may correspond to a unit to form an image to be displayed on the display panel DP (refer to FIG. 10). More specifically, the light emitting parts EP1, EP2, and EP3 may correspond to a region defined by the light emitting opening part OP-PDL (refer to FIG. 10), especially, a region defined by the bottom surface of the light emitting opening part OP-PDL.

The light emitting parts EP1, EP2, and EP3 may include the first light emitting part EP1, the second light emitting part EP2, and the third light emitting part EP3. The first light emitting part EP1, the second light emitting part EP2, and the third light emitting part EP3 may emit first color light, second color light, and third color light, respectively, and the first to third color lights may be lights in different colors. For example, the first light emitting part EP1 may emit red light, the second light emitting part EP2 may emit green light, and the third light emitting part EP3 may emit blue light, but the combination of colors is not limited thereto. In addition, at least two of the light emitting parts EP1, EP2, and EP3 may emit light in the same color. For example, all of the first to third light emitting parts EP1, EP2, and EP3 may emit blue light or white light.

Meanwhile, among the light emitting parts EP1, EP2, and EP3, the third light emitting part EP3 to emit third color light may include two sub-light emitting parts EP31 and EP32 spaced apart from each other in the second direction DR2. However, this is provided only for the illustrative purpose. The third light emitting part EP3 may be provided in one pattern having an integral shape, which similar to the remaining light emitting parts EP1 and EP2, or at least one of the remaining light emitting parts EP1 or EP2 may include sub-light emitting parts spaced apart from each other. However, embodiments according to the present disclosure are not limited to any one embodiment.

The light emitting parts in the first row Rk may include the light emitting parts EP1, EP2, and EP3 constituting the light emitting units UT11 in the first row and the first column, and the light emitting units UT12 in the first row and the second column. The light emitting parts in the second row Rk+1 may include the light emitting parts EP1, EP2, and EP3 constituting the light emitting units UT21 in the second row Rk+1 and the first row and the light emitting units UT22 in the second column and the second row Rk+1. Some of the light emitting parts in the first row Rk may have the form symmetrical to the form of the light emitting parts in the second row Rk+1. For example, the first light emitting part EP1 and the second light emitting part EP2 of the light emitting unit UT21 in the second row Rk+1 and the first column, and the first light emitting part EP1 and the second light emitting part EP2 of the light emitting unit UT11 in the first row Rk and the first column may have the shape and an arrangement form linear-symmetrical to an axis parallel to the second direction DR2. The third light emitting part EP3 of the light emitting unit UT21 in the second row Rk+1and the first column and the third light emitting part EP3 of the light emitting unit UT11 in the first row Rk and the first column may have the shape and the arrangement form linear-symmetrical to the axis parallel to the first direction DR1. However, this is provided only for the illustrative purpose, and embodiments according to the present disclosure are not limited thereto.

Hereinafter, the light emitting unit UT11 in the first row Rk and first column will be described. FIG. 13B illustrates a plurality of cathodes CE_1, CE_2, and CE_3, a plurality of pixel drivers PXCR, PXCG, and PXCB, and a plurality of connection wires CN1, CN2, and CN3, for the convenience of more ease of explanation. The cathodes CE_1, CE_2, and CE_3 may be separated from each other by the separator SPR to be electrically open-circuited with respect to each other. According to some embodiments, one light emitting unit UT may include three light emitting parts EP1, EP2, and EP3. Accordingly, the light emitting unit UT may include the three cathodes CE_1, CE_2, and CE_3 (hereinafter, referred to as "first to third cathodes"), the three pixel drivers PXCR, PXCG, and PXCB, and the three connection wires CN1, CN2, and CN3. However, this is provided only for the illustrative purpose. The number and the arrangement of the light emitting unit UT may be variously designed. However, embodiments according to the present disclosure are not limited to any one embodiment.

The first to third pixel drivers PXCR, PXCG, and PXCB are electrically connected to light emitting elements constituting the first to third light emitting parts EP1, EP2, and EP3. In this specification, the wording "connected" includes the concepts of not only "connected through mechanically direct contract", but also "electrically connected".

In addition, as illustrated in FIG. 13B, regions for the pixel drivers PXCR, PXCG, and PXCB defined when viewed in a plan view may correspond to units in which transistor and capacitor elements constituting the pixel PX (refer to FIG. 2) to drive the light emitting element of the pixel are repeated and arranged. For example, each of the first to third pixel drivers PXCR, PXCG, and PXCB may include the first to seventh transistors T1 to T7, the first capacitor Cst, and the second capacitor Cth illustrated in FIG. 2.

The first to third pixel drivers PXCR, PXCG, and PXCB may be sequentially arranged in the first direction DR1. Meanwhile, the arrangement positions of the first to third pixel drivers PXCR, PXCG, and PXCB may be independently designed regardless of the positions or the shapes of the first to third light emitting parts EP1, EP2, and EP3.

For example, the first to third pixel drivers PXCR, PXCG, and PXCB may be located at positions different from positions of regions separated and defined by the separator SPR, that is, positions for the first to third cathodes CE_1, CE_2, and CE_3. In addition, the first to third pixel drivers PXCR, PXCG, and PXCB may be designed to have shapes and areas different from those of the first to third cathodes CE_1, CE_2, and CE_3. Alternatively, the first to third pixel drivers PXCR, PXCG, and PXCB may be overlapped with positions for the first to third light emitting parts EP1, EP2, and EP3, and may be designed in shape and area approximate to the shape and the area of the regions separated and defined by the separator SPR, for example, the regions for the first to third cathodes CE_1, CE_2, and CE_3.

According to some embodiments, each of the first to third pixel drivers PXCR, PXCG, and PXCB is illustrated in the shape of a rectangle. Each of the first to third light emitting parts EP1, EP2, and EP3 is arranged with area smaller than an area of the rectangle and in shape different from the shape of the rectangle. The first to third cathodes CE_1, CE_2, and CE_3 are located at positions overlapped with the first to third light emitting parts EP1, EP2, and EP3, in an amorphous shape, as illustrated in drawings.

Accordingly, as illustrated in FIG. 13B, the first pixel driver PXCR may be located at a position partially overlapped with the first light emitting part EP1, the second light emitting part EP2, and an adjacent different light emitting units. The second pixel driver PXCG may be located at a position overlapped with the first light emitting part EP1, the second light emitting part EP2, and the third light emitting part EP3. The third pixel driver PXCB may be located at a position overlapped with the third light emitting part EP3. Meanwhile, this is provided only for the illustrative purpose. The positions of the first to third pixel drivers PXCR, PXCG, and PXCB may be designed in various forms and various arrays, independently from the light emitting parts EP1, EP2, and EP3. However, embodiments according to the present disclosure are not limited to any one embodiment.

A plurality of connection wires CN may be provided to be spaced apart from each other. One connection wire CN may electrically connect any one pixel driver among the pixel drivers PXCR, PXCG, and PXCB to a light emitting element corresponding to the one pixel driver. For example, the connection wire CN may correspond to the first node N1 (refer to FIG. 2) to connect the light emitting element ED (refer to FIG. 10) to the fifth transistor T5 (refer to FIG. 2).

The connection wire CN may include a first connection part (or the light emitting connection part CEP) and a second connection part (or the driving connection part CDP). The light emitting connection part CEP may be provided at one side of the connection wire CN and the driving connection part CDP may be provided at an opposite side of the connection wire CN.

The driving connection part CDP may be a portion, which is connected to transistor TR, of the connection wire CN. According to some embodiments, the driving connection part CDP may be connected to one electrode of the transistor TR. In detail, the driving connection part CDP may be connected to the first electrode of the fifth transistor T5 illustrated in FIG. 2. Accordingly, the position of the driving connection part CDP may correspond to the position of the transistor TR (refer to FIG. 10) physically connected to the connection wire CN. The light emitting connection part CEP may be a portion, which is connected to the light emitting element ED, of the connection wire CN. According to some embodiments, the light emitting connection part CEP may be connected to the cathode CE (refer to FIG. 10) of the light emitting element.

The light emitting unit UT may include the first to third connection wires CN1, CN2, and CN3. The first connection wire CN1 may connect the light emitting element forming the first light emitting part EP1 to the first pixel driver PXCR, the second connection wire CN2 may connect the light emitting element forming the second light emitting part EP2 to the second pixel driver PXCG, and the third connection wire CN3 may connect the light emitting element forming the third light emitting part EP3 to the third pixel driver PXCB.

In detail, the first to third connection wires CN1, CN2, and CN3 may connect the first to third cathodes CE_1, CE_2, and CE_3 to the first to third pixel drivers PXCR, PXCG, and PXCB, respectively. The first connection wire CN1 may include the first driving connection part CDP1 connected to the first pixel driver PXCR and the first light emitting connection part CEP1 connected to the first cathode CE_1. The second connection wire CN2 may include the second driving connection part CDP2 connected to the second pixel driver PXCG and the second light emitting connection part CEP2 connected to the second cathode CE_2. The third connection wire CN3 may include the third driving connection part CDP3 connected to the third pixel driver PXCB and the third light emitting connection part CEP3 connected to the third cathode CE_3

The first to third driving connection parts CDP1, CDP2, and CDP3 may be aligned in the first direction DR1. As described above, the first to third driving connection parts CDP1, CDP2, and CDP3 may correspond to positions of transistors constituting the first to third pixel drivers PXCR, PXCG, and PXCB. According to the present disclosure, the shapes, the positions, and the arrangement of the pixel drivers of all pixels may be simply configured and designed, regardless of the shape, the size, and the light emitting color of the light emitting part

According to some embodiments, the first to third light emitting connection parts CEP1, CEP2, and CEP3 may be located in a non-overlap position with the light emitting parts EP1, EP2, and EP3, when viewed in a plan view. As described below, each of the light emitting connection parts CEP1, CEP2, and CEP3 of the connection wires CN is a part for the connection of the light emitting element ED (refer to FIG. 10), and the tip part TP (refer to FIG. 10) is defined in each of the light emitting connection parts CEP1, CEP2, and CEP3. Accordingly, each of the light emitting connection parts CEP1, CEP2, and CEP3 may be provided at a position in the non-overlap position with the light emitting open part OP-PDL (refer to FIG. 10). In other words, light emitting connection parts CEP1, CEP2, and CEP3 may be located at positions spaced apart from the light emitting parts EP1, EP2, and EP3 in the cathodes CE_1, CE_2, and CE_3. The cathodes CE_1, CE_2, and CE_3 may include some regions protruding from the light emitting parts EP1, EP2, and EP3 to be connected to the connection wires CN1, CN2, and CN3 at the positions for the light emitting connection parts CEP1, CEP2, and CEP3.

For example, the first cathode CE_1 may include a protruding part having the shape of protruding from the first light emitting part EP1, which is provided in a non-overlap position with the first light emitting part EP1, such that the first cathode CE_1 is connected to the first connection wire CN1 at the position for the first light emitting connection part CEP1.

In addition, the first pixel driver PXCR, especially, the first driving connection part CDP1 provided at a position for the first connection wire CN1 to be connected to the transistor TR (refer to FIG. 10) may be defined in the non-overlap position with the first light emitting part EP1, when viewed in a plan view. According to some embodiments, as the first connection wire CN1 is located in the first light emitting part EP1, the first cathode CE1 and the first pixel driver PXCR spaced apart from each other may be easily connected to each other.

Meanwhile, the third pixel driver PXCB, especially, the third driving connection part CDP3 provided at a position for the third connection wire CN3 to be connected to the transistor TR (refer to FIG. 3) may be defined in the non-overlap position with the third light emitting connection part CEP3 and may be provided at a position overlapped with the third light emitting part EP3, when viewed in a plan view. According to some embodiments, as the third cathode CE_3 and the third pixel driver PXCB are connected to each other through the third connection wire CN3, the degree of freedom in design of the third pixel driver PXCB may be relatively improved, as the restriction for the position or the shape of the third light emitting part EP3 is reduced.

Referring back to FIG. 13A, the light emitting parts in the second row Rk+1 may include light emitting parts in which the first light emitting units UT11 and UT12 in the first row Rk have shapes and arrangement linear-symmetrical to the axis parallel to the first direction DR1 or the second direction DR2. In this case, due to the features of the shapes and the arrangement of the light emitting units UT11 and UT12 in the first row Rk, the light emitting units UT21 and UT22 in the second row Rk+1 may include light emitting parts provided by shifting the light emitting units UT11 and UT12 in the first row Rk in the first direction DR1 or the second direction DR2. In other words, the light emitting unit UT21 in the second row Rk+1 and the first row Rk includes light emitting parts having the same shape as the light emitting unit UT12 in the first row Rk and the second column, and the light emitting unit UT22 in the second row Rk+1 and the second column includes light emitting parts having the same shape as the light emitting unit UT11 in the first row Rk and the first column

Accordingly, the shape and the arrangement of the connection wires CN-c located in the light emitting unit UT21 in the second row Rk+1and the first column may be the same as those of the connection wires CN1, CN2, and CN3 located in the light emitting unit UT12 in the first row Rk and the second column. Similarly, the shape and the arrangement of the connection wires CN-c located in the light emitting unit UT22 in the second row Rk+1 and the second column may be the same as those of the connection wires CN1, CN2, and CN3 located in the light emitting unit UT11 in the first row Rk and the first column.

Meanwhile, referring to FIG. 13C, according to some embodiments of the present disclosure, the anode AE of the light emitting element may be provided for the plurality of light emitting parts EP1, EP2, and EP3 in common. In other words, the anode AE may be integrally formed in one layer, for the entire portion of the display region DA. Accordingly, the layer of the anode AE may be overlapped with the separator SPR. Alternatively, the anodes AE of the light emitting elements are formed in the form of conductive patterns spaced apart from each other and independent from each other, may be electrically connected to each other through a different conductive layer. Accordingly, the anode patterns may be located in a non-overlap state with the separator SPR.

As described above, the anode AE may be applied with the first driving voltage ELVDD (refer to FIG. 2), and all light emitting parts may receive a common voltage. The anode AE may be connected to the first driving voltage line VL1 (refer to FIG. 2) to provide the first driving voltage ELVDD (refer to FIG. 2) in the non-display region NDA, or may be connected to the first driving voltage line VL1 (refer to FIG. 2) in the display region DA. However, embodiments according to the present disclosure are not limited to any one embodiment. When the anode AE is connected to the first driving voltage line VL1 in the display region DA, the first driving voltage line VL1 may be located in the non-display region NDA (refer to FIG. 1) and the anode AE may have the shape extending to the non-display region NDA (refer to FIG. 1).

Although it is illustrated that the anode AE may be overlapped with the light emitting opening part OP-PDL and may be in the non-overlap state with the separator SPR when viewed the cross-section of FIGS. 10 and 12, the anodes AE of the light emitting elements has an integral form, may have a mesh shape or a lattice shape in which opening parts are defined in some regions. In other words, when the first driving voltage ELVDD (refer to FIG. 2) may be identically applied to the anode AE of each of the plurality of light emitting elements, the shape of the anode AE may be variously provided. However, embodiments according to the present disclosure are not limited to any one embodiment.

Meanwhile, according to some embodiments, the plurality of opening parts OP-AE may be defined in the anode AE. The opening parts OP-AE may pass through a layer for the anode AE. The opening parts OP-AE of the layer for the anode AE may be provided in the non-overlap position with the light emitting parts EP. The opening parts OP-AE of the layer for the anode AE may be almost defined at a position overlapped with the separator SPR. The opening parts OP-AE may facilitate the emission of gas generated from an organic layer, for example, the upper insulating layer UIL (refer to FIG. 10) located under the anode AE. Accordingly, the gas from the organic layer located under the light emitting element ED may be sufficiently emitted in the fabricating process of the display panel DP. After fabricating the display panel DP, the gas emitted from the organic layer may be reduced to reduce the rate in which the light emitting element ED is deteriorated.

According to some embodiments, as the connection wire is provided between the light emitting element ED and the pixel driver, the light emitting element ED may be easily connected to the pixel driver, even if only the shape of the cathode CE is changed without changing the arrangement or the shape of the light emitting part. Accordingly, the degree of freedom in design may be relatively improved with respect to the arrangement of the pixel driver, and the area or the resolution of the light emitting part of the display panel DP may be easily increased.

The change in characteristic, which results from the deterioration of the light emitting element ED, is not transferred to the first transistor. Accordingly, degradation of the display quality due to the deterioration of the light emitting element may be prevented or reduced.

Because the threshold voltage of the first transistor may be set to 0 V for the initializing period and the compensating period, the influence by the threshold voltage of the first transistor may be reduced or minimized.

Although aspects of some embodiments of the present disclosure have been described for illustrative purposes, those skilled in the art will appreciate that various modifications, and substitutions are possible, without departing from the scope of the present disclosure as disclosed in the accompanying claims. Accordingly, the technical scope of embodiments according to the present disclosure are not limited to the detailed description of this specification, but should be defined by the claims, and their equivalents.

While the present disclosure has been described with reference to embodiments thereof, it will be apparent to those of ordinary skill in the art that various changes and modifications may be made thereto without departing from the scope of the present disclosure as set forth in the following claims.

Embodiments are set out in the following clauses:
Clause 1. A pixel comprising:
   a light emitting element including an anode connected to a first driving voltage line and a cathode connected to a first node;
   a first transistor including a first electrode, a second electrode, a gate electrode, and a lower gate electrode;
   a second transistor connected between a data line and a second node,
   a third transistor connected between the second electrode and a third driving voltage line;
   a fourth transistor connected between a fourth driving voltage line and the first node;
   a fifth transistor connected between the first node and the first electrode of the first transistor;
   a sixth transistor connected between the second electrode of the first transistor and a second driving voltage line;
   a seventh transistor connected between the first electrode of the first transistor and the gate electrode;
   a first capacitor connected between the gate electrode of the first transistor and the second node; and
   a second capacitor connected between a fifth driving voltage line and the second node.
Clause 2. The pixel of clause 1, wherein the second transistor includes a gate electrode configured to receive a first scan signal,
   wherein each of the third transistor and the seventh transistor includes a gate electrode configured to receive a third scan signal,
   wherein the fourth transistor includes a gate electrode configured to receive a second scan signal,
   wherein the fifth transistor includes a gate electrode configured to receive a first light emitting signal, and
   wherein the sixth transistor includes a gate electrode configured to receive a second light emitting signal.
Clause 3. The pixel of clause 1 or clause 2, wherein the third transistor, the fourth transistor, the fifth transistor, and the seventh transistor are configured to be turned on for an initializing period.
Clause 4. The pixel of clause 3, wherein the first transistor, the third transistor, the sixth transistor, and the seventh transistor are configured to be turned on for a compensating period.
Clause 5. The pixel of clause 4, wherein the initializing period and the compensating period are alternately repeated twice.
Clause 6. The pixel of any of clauses 1-5, wherein the second transistor is configured to be turned on for a write period.
Clause 7. The pixel of any of clauses 1 to 6, wherein the fourth transistor is configured to be turned on for a light emitting element initializing period.
Clause 8. The pixel of any of clauses 1 to 7, wherein the first transistor, the fifth transistor, and the sixth transistor are configured to be turned on for a light emitting period.
Clause 9. An electronic device comprising:
   a display panel including a pixel; and
   a data driving circuit configured to provide a data signal to the pixel,
   wherein the pixel includes:
      a light emitting element including an anode connected to a first driving voltage line and a cathode connected to a first node;
      a first transistor including a first electrode, a second electrode, a gate electrode, and a lower gate electrode;
      a second transistor connected between a data line for transmitting the data signal and the gate electrode of the first transistor;
      a fifth transistor connected between the first node and the first electrode of the first transistor;
      a sixth transistor connected between the second electrode of the first transistor and a second driving voltage line;
      a seventh transistor connected between the first electrode of the first transistor and the lower gate electrode;
      a first capacitor connected between the gate electrode of the first transistor and the second electrode; and
      a second capacitor connected between the lower gate electrode of the first transistor and the second electrode.
Clause 10. The electronic device of clause 9, wherein, in the pixel, the second transistor includes:
   a gate electrode configured to receive a first scan signal,
   wherein the fifth transistor includes:
      a gate electrode configured to receive a first light emitting signal,
   wherein the sixth transistor includes:
      a gate electrode configured to receive a second light emitting signal, and
   wherein the seventh transistor includes:
      a gate electrode configured to receive a second scan signal.
Clause 11. The electronic device of clause 10, wherein the pixel further includes:
   a third transistor connected between a third driving voltage line configured to receive a first initializing voltage and the gate electrode of the first transistor, and including a gate electrode configured to receive the second scan signal; and
   a fourth transistor connected between a fourth driving voltage line configured to receive a second initializing voltage and the first electrode of the first transistor, and including a gate electrode configured to receive a third scan signal.
Clause 12. The electronic device of clause 11, further comprising:
   a scan driving circuit configured to provide the first scan signal, the second scan signal, and the third scan signal;
   a light emitting driving circuit configured to provide the first light emitting signal and the second light emitting signal; and
   a voltage generator configured to provide a first driving voltage, a second driving voltage, the first initializing voltage, and the second initializing voltage to the first to fourth driving voltage lines.
Clause 13. The electronic device of clause 11 or clause 12, wherein the third transistor, the fourth transistor, the fifth transistor, and the seventh transistor are configured to be turned on for an initializing period, and
   wherein a threshold voltage of the first transistor is negative-shifted for the initializing period.
Clause 14. The electronic device of any of clauses 11-13, wherein the first transistor, the third transistor, the sixth transistor, and the seventh transistor are configured to be turned on for a compensating period, and
   wherein the threshold voltage of the first transistor is set to 0 V for the compensating period.

## Claims

1. A pixel comprising:
a light emitting element including an anode connected to a first driving voltage line and a cathode connected to a first node;
a first transistor including a first electrode, a second electrode, a gate electrode, and a lower gate electrode;
a second transistor connected between a data line and the gate electrode of the first transistor;
a fifth transistor connected between the first node and the first electrode of the first transistor;
a sixth transistor connected between the second electrode of the first transistor and a second driving voltage line;
a seventh transistor connected between the first electrode of the first transistor and the lower gate electrode;
a first capacitor connected between the gate electrode of the first transistor and the second electrode; and
a second capacitor connected between the lower gate electrode of the first transistor and the second electrode.

2. The pixel of claim 1, wherein the second transistor includes:
a gate electrode configured to receive a first scan signal,
wherein the fifth transistor includes:
a gate electrode configured to receive a first light emitting signal,
wherein the sixth transistor includes:
a gate electrode configured to receive a second light emitting signal, and
wherein the seventh transistor includes:
a gate electrode configured to receive a second scan signal.

3. The pixel of claim 1 or claim 2, further comprising
a third transistor connected between a third driving voltage line configured to receive a first initializing voltage and the gate electrode of the first transistor; and
a fourth transistor connected between a fourth driving voltage line configured to receive a second initializing voltage and the first node.

4. The pixel of claim 3, wherein the second initializing voltage has a voltage level higher than a voltage level of the first initializing voltage.

5. The pixel of claim 3 or claim 4, wherein the second initializing voltage has a voltage level higher than a voltage level of a second driving voltage received through the second driving voltage line.

6. The pixel of any of claims 3-5, wherein the third transistor includes:
a gate electrode configured to receive a second scan signal, and
wherein the fourth transistor includes:
a gate electrode configured to receive a third scan signal.

7. The pixel of any of claims 3-6, wherein the third transistor, the fourth transistor, the fifth transistor, and the seventh transistor are configured to be turned on for an initializing period.

8. The pixel of claim 7, wherein a threshold voltage of the first transistor is negative-shifted for the initializing period.

9. The pixel of claim 8, wherein the first transistor, the third transistor, the sixth transistor, and the seventh transistor are configured to be turned on for a compensating period.

10. The pixel of claim 9, wherein the threshold voltage of the first transistor is configured to be set to 0 V for the compensating period.

11. The pixel of any of claims 3-10, wherein the second transistor and the sixth transistor are configured to be turned on for a write period.

12. The pixel of any of claims 3-11, wherein the fourth transistor is configured to be turned on for a light emitting element initializing period.

13. The pixel of any of claims 3-12, wherein the first transistor, the fifth transistor, and the sixth transistor are configured to be turned on for a light emitting period.

14. The pixel of any preceding claim, wherein each of the first transistor, the second transistor, the fifth transistor, the sixth transistor, and the seventh transistor is an N-type transistor.

15. An electronic device comprising:
a display panel including a pixel; and
a data driving circuit configured to provide a data signal to the pixel,
wherein the pixel includes:
a light emitting element including an anode connected to a first driving voltage line and a cathode connected to a first node;
a first transistor including a first electrode, a second electrode, a gate electrode, and a lower gate electrode;
a second transistor connected between a data line configured to transmit the data signal and the gate electrode of the first transistor;
a fifth transistor connected between the first node and the first electrode of the first transistor;
a sixth transistor connected between the second electrode of the first transistor and a second driving voltage line;
a seventh transistor connected between the first electrode of the first transistor and the lower gate electrode;
a first capacitor connected between the gate electrode of the first transistor and the second electrode; and
a second capacitor connected between the lower gate electrode of the first transistor and the second electrode.
